# EUROPÄISCHE PATENTSCHRIFT

(11) **EP 2 681 817 B1**
(45) Veröffentlichungstag und Bekanntmachung des Hinweises auf die Patenterteilung: **08.04.2015**
(21) Anmeldenummer: 12718891.0
(22) Anmeldetag: 17.02.2012
(51) Int. Cl.: H02B 1/30

(54) **SOCKEL ODER ANBAURAHMEN FÜR EINEN SCHALTSCHRANK ODER EIN RACK**
BASE OR MOUNTING FRAME FOR A CABINET OR RACK
BASE OU CHÂSSIS DE MONTAGE POUR UNE ARMOIRE OU UN RACK

(30) Priorität: 28.02.2011 DE 102011013160
(43) Veröffentlichungstag der Anmeldung: 08.01.2014
(73) Patentinhaber: RITTAL GmbH & Co. KG, 35745 Herborn (DE)
(72) Erfinder: BRÖMSTRUP, Dennis, 49080 Osnabrück (DE); BÖHME, Siegfried, 06766 Wolfen (DE); HOLIGHAUS, Heiko, 35713 Eschenburg (DE); MÜLLER, Matthias, 35683 Dillenburg (DE); SCHNAKENBERG, Michael, 49134 Wallenhorst (DE)
(74) Vertreter: Tönhardt, Marion
(86) Internationale Anmeldenummer: PCT/DE2012/000156
(87) Internationale Veröffentlichungsnummer: WO 2012/116673

(56) Entgegenhaltungen:
- DE-A1- 10 328 407
- US-A- 5 655 821
- US-A1- 2005 056 758

## Beschreibung

Die Erfindung bezieht sich auf einen Sockel oder Anbaurahmen für einen Schaltschrank oder ein Rack mit in den Eckbereichen eines in einer x-y-Ebene sich erstreckenden Rechtecks oder Quadrats als Eckstücke angeordneten Montagestücken, die jeweils in einem Formungsprozess hergestellt und eine sich in x-Richtung und eine sich dazu rechtwinklig in y-Richtung erstreckende bezüglich des Rechtecks oder Quadrats außen liegende und in zur x-y-Ebene rechtwinkliger Raumrichtung z ausgedehnte erste und zweite Anbauseiten aufweisen, an denen Abschnitte einer Anordnung von Blenden in Anlage gebracht sind, wobei die Blenden Seitenblenden mit einer außen flachen mit in Längsrichtung verlaufenden Versteifungsrippen Blendenwand umfassen und über Verbindungsmittel an Aufnahmestrukturen der Montagestücke angebracht sind, wobei die Seitenblenden mit auf ihrer Innenseite angeformten Blendenbefestigungselementen versehen sind, mit denen sie unmittelbar oder mittelbar an den Aufnahmestrukturen der Montagestücke befestigt sind, wobei sich die Blendenbefestigungselemente in Längsrichtung der Seitenblenden auf einer Innenseite der Blendenwand erstrecken. Ein derartiger Sockel oder Anbaurahmen ist aus der US 5,655,821 A bekannt.

Ein ähnlicher Sockel oder Anbaurahmen für einen Schaltschrank ist in der DE 195 34 551 C1 angegeben. In den Eckbereichen des in Draufsicht rechteckförmigen Sockels sind als Eckstücke Montagestücke angeordnet, die über seitliche Blenden miteinander verbunden sind. Die Eckstücke sind dabei als aufrecht stehende Profilabschnitte aus einem stranggepressten Aluminiumprofil ausgeführt, die mehrere in Profillängsrichtung verlaufende, von Wandteilen umgrenzte, zum Teil offene und zum Teil geschlossene Hohlräume aufweisen. Die bezüglich des Sockels außen angeordneten Anbauseiten der Eckstücke weisen in Profillängsrichtung verlaufende Schlitze zu dahinter liegenden Hohlräumen auf, die T-förmige Befestigungsnuten bilden, über die die Blenden mittels Schrauben angebracht sind, welche in in den Nuten angeordnete Muttern eingreifen. Diese Ausbildung führt zu einem nicht unerheblichen Montageaufwand, insbesondere wenn die Blenden für Installationszwecke z. B. an schlecht zugänglichen Stellen entfernt und wieder angebracht werden müssen.

Bei einem in der EP 0 725 464 B1 gezeigten weiteren Sockel weisen die Eckstücke eine obere und untere Verbindungsplatte auf, die über rippenförmig ausgebildete, senkrechte Wände miteinander verbunden sind, wobei seitlich vorstehende Befestigungsplatten mit Bohrungen vorhanden sind, an denen Blenden angebracht werden. Auch diese Ausbildung kann zu ungünstigem Montageaufwand führen.

Weitere mit Blenden ausrüstbare Sockel sind in der DE 10 2007 013 520 A1, der WO 02/080322 A1, der DE 37 10 567 C2, der DE 84 10 203 U1, der DE 43 10 079 C2, der DE 93 08 162 U1, der DE 103 28 407 A1 und der EP 0 686 316 B1 gezeigt. Diese bekannten Sockel weisen als abgewinkelte Stanz-/Biegeteile ausgeführte Eckstücke auf, an denen die Blenden anzubringen sind, wobei sich ebenfalls ein nicht unerheblicher Montageaufwand ergeben kann.

Der Erfindung liegt die Aufgabe zugrunde, einen Sockel oder Anbaurahmen der eingangs genannten Art bereit zu stellen, mit dem verbesserte Montagemöglichkeiten erreicht werden.

Diese Aufgabe wird mit den Merkmalen des Anspruches 1 gelöst. Hierbei ist vorgesehen, dass die Blendebefestigungselemente rechtwinklig von der Innenseite der Blendenwand vorstehen, so dass sie Versteifungselemente bilden, und dass die Seitenblenden aus Metall oder vorzugsweise Kunststoff in einem Strangformungs-prozess gefertigt sind, wobei die Seitenblenden wahlweise an der Innenseite der Blendenwand mit in Längsrichtung verlaufenden Versteifungsrippen versehen sind.

Die Blenden lassen sich damit einfach anbringen und leicht entfernen, wobei Befestigungselemente nicht umständlich angebracht werden müssen und auch nicht verloren gehen können. Dadurch werden z. B. Installationsarbeiten insbesondere an schlecht zugänglichen Stellen vereinfacht.

Die Handhabung bei der Montage wird ferner dadurch begünstigt, dass die Blendenbefestigungselemente als Klipselemente oder als Rastelemente mit flacher Einführschräge und steilem Rastabsatz ausgebildet sind und unter federelastischer Auslenkung an darauf abgestimmten Aufnahmestrukturen an den Anbauseiten der Montagestücke oder an zwischen den Montagestücken verlaufenden und mit ihren Endabschnitten an diesen angebrachten weiteren Zwischenelementen, wie Montageschiene oder C-Schiene, in Eingriff gebracht oder bringbar sind, um die Seitenblenden zu fixieren, wobei die Blendenbefestigungselemente und/oder die Aufnahmestrukturen federelastisch auslenkbar sind.

Für die Montage sind auch die Maßnahmen von Vorteil, dass die Anordnung der Blenden auch Eckblenden umfasst, die zum Abdecken der außen liegenden Eckbereiche der Montagestücke ausgebildet sind.

Dabei wird eine einfache Anbringung dadurch erreicht, dass die Eckblenden auf ihrer Innenseite mit angeformten Eckblendenbefestigungselementen versehen sind, mit denen sie unmittelbar oder mittelbar an zugeordneten Aufnahmestrukturen des Montagestückes anbringbar sind.

Zu einer vorteilhaften Herstellung tragen dabei die Maßnahmen bei, dass auch die Eckblenden aus Metall oder vorzugsweise Kunststoff geformt sind und auf der Innenseite ihrer plattenförmigen Eckblendenwände mit angeformten Versteifungsstrukturen versehen sind.

Die Maßnahmen, dass die Eckblenden zum Herstellen eines glatten Übergangs von ihrer Außenseite zur Außenseite der Seitenblenden mit den zugekehrten Endabschnitten der Seitenblenden überlappende Endabschnitte aufweisen, die um die Dicke der Blendenwand z-förmig nach innen abgesetzt sind, tragen dabei vorteilhaft zur optischen Gestaltung und auch zu einer einfachen, eindeutigen Anordnung der Blenden bei, ohne dass an den Übergangsstellen störende Spalte entstehen.

Weitere Montagevorteile werden dadurch erreicht, dass die Aufnahmestrukturen der Montagestücke parallel zu der betreffenden Anbauseite verlaufende Aufnahmekammern aufweisen, die von in ihrer Orientierungsrichtung verlaufenden Wandabschnitten zumindest teilweise umgeben und auf ihren voneinander abgekehrten Stirnseiten offen sind, und/oder dass die Aufnahmestrukturen Aufnahmerippen, Aufnahmenuten, Aufnahmestege, andere Vorsprünge und/oder andere Vertiefungen aufweisen und dass zumindest ein Teil der Aufnahmestrukturen mit Befestigungsmitteln, insbesondere angeformten Rastmitteln, versehen ist, die mit den Blenden und/oder mit zwischen den Montagestücken verlaufenden Zwischenelementen in Eingriff bringbar sind.

Mit den Maßnahmen, dass die Montagestücke in z-Richtung von einer ersten und einer davon in einem Abstand parallel beabstandeten zweiten Grundseite abgeschlossen sind, die in der x-y-Ebene orientiert sind und die Außenseite mindestens eines ersten und mindestens eines zweiten Grundwandabschnitts bilden, und dass die Anbauseiten an ihren einander zugekehrten Enden voneinander beabstandet sind und in dem betreffenden ersten gedachten Eckbereich des Montagestücks einen ersten Eckraum bilden, der mit Blenden der Anordnung abdeckbar ist, werden insbesondere auch in den Eckbereichen vorteilhafte Montagemöglichkeiten geboten, wobei dort Installationselemente vorteilhaft angebracht werden können und in systematischer Fortführung ein Freiraum erhalten wird, der einen gegebenenfalls im Kantenbereich eines sich in z-Richtung anschließenden Rahmengestells vorhandenen Freiraum ergänzt.

Für die Montage weitere vorteilhafte Maßnahmen bestehen darin, dass sich auf den Innenseiten der voneinander weg gerichteten Enden der ersten und der zweiten Anbauseite weitere Wandbereiche anschließen, die miteinander einstöckig verbunden sind und zwischen ihren einander zugekehrten Enden einen zweiten Eckraum freilassen, der in z-Richtung mittels des ersten und des zweiten Grundwandabschnittes begrenzt ist. Beispielsweise kann an einem in dem zweiten Eckraum vorhandenen Grundwandabschnitt vorteilhaft ein Verankerungsmittel mit einer Verankerungsklaue zum Befestigen des Sockels auf einem Untergrund in Eingriff gebracht werden.

Für die Handhabung und Herstellung bestehen weitere vorteilhafte Maßnahmen darin, dass die Montagestücke als blockartige Kunststoffformteile ausgebildet sind.

Weitere Ausgestaltungsmöglichkeiten werden dadurch erreicht, dass zum Bilden eines Rahmens doppelter oder mehrfacher Höhe in den Eckbereichen jeweils zwei oder mehr Montagestücke in z-Richtung angeordnet und miteinander verbunden sind. Hierbei ist vorteilhaft, wenn die Montagestücke auf ihren gegenüberliegenden Grundseiten mit komplementären Aufnahmestrukturen versehen sind, mit denen sie mit ihren Außenkonturen bündig in z-Richtung aneinander gereiht werden können. In z-Richtung verlaufende Bohrungen, die in den aneinander gereihten Montagestücken vorhanden sind und miteinander fluchten, können vorteilhaft für die Verbindung genutzt werden oder es sind auch in z-Richtung wirkende, miteinander in Eingriff tretende Rastelemente oder sonstige Verbindungselemente vorhanden.

Die Erfindung wird nachfolgend anhand von Ausführungsbeispielen unter Bezugnahme auf die Zeichnungen näher erläutert. Es zeigen:
- Fig. 1A und 1B: Darstellungen eines Montagestückes in perspektivischer Ansicht auf zwei entgegen gesetzte Eckbereiche,
- Fig. 2A und 2B: weitere perspektivische Ansichten des Montagestückes (bezüglich eines eingebauten Zustandes von innen links bzw. von innen rechts),
- Fig. 2C bis 2F: weitere verschiedene Ansichten des Montagestückes (bezüglich eines eingebauten Zustandes von unten, von innen links, von innen rechts bzw. von vorn),
- Fig. 3A und 3B: weitere perspektivische Ansichten des Montagestückes (bezüglich eines eingebauten Zustandes von innen bzw. von außen),
- Fig. 3C bis 3F: verschiedene Ansichten des Montagestückes (bezüglich eines eingebauten Zustandes von oben, von rechts, von vorn bzw. von links),
- Fig. 4: das Montagestück mit verschiedenen anbringbaren Montageelementen in perspektivischer Ansicht,
- Fig. 5A und 5B: perspektivische Ansichten des Montagestückes mit in einem Eckbereich angeordneten Nivellierelementen während eines Montagevorgangs,
- Fig. 6: das Montagestück in perspektivischer Ansicht mit in einem Eckbereich angeordnetem Stützfuß,
- Fig. 7: einen Ausschnitt einer Konstruktionseinheit, beispielsweise eines Sockels, mit einem Montagestück, einer Montageschiene und einer C-förmigen Schiene sowie einem Verankerungsmittel in perspektivischer Ansicht,
- Fig. 8A und 8B: einen Ausschnitt einer Konstruktionseinheit mit dem Montagestück, einer Montageschiene, einer C-Schiene und einer an dem Montagestück angebrachten Rolleneinheit bzw. zusätzlich einem Verankerungsmittel,
- Fig. 9A: das Montagestück mit einer montierten Rolleneinheit,
- Fig. 9B, 9C und 9D: verschiedene Rolleneinheiten mit Haltegliedern und Stützplatten,
- Fig. 10A: ein weiteres Ausführungsbeispiel für eine Rolleneinheit mit Halteglied in perspektivischer Ansicht,
- Fig. 10B: Beispiele für die Anbringung einer Rolleneinheit nach Fig. 10A an dem Montagestück,
- Fig. 11 A: einen Ausschnitt einer Konstruktionseinheit mit einem Montagestück und daran angebrachten C-Schienen und einer Montageschiene sowie einer anzubringenden Montageschiene in perspektivischer Ansicht,
- Fig. 11 B: die Konstruktionseinheit nach Fig. 11A bei angebrachten C-Schienen und Montageschienen,
- Fig. 11C: die Konstruktionseinheit nach Fig. 11A in seitlicher Ansicht,
- Fig. 12A bis 12D: eine in Draufsicht quadratische Konstruktionseinheit mit vier Montagestücken als Eckstücke sowie diese verbindenden Zwischenelementen in Form von Montageschienen und C-Schienen in Draufsicht, seitlicher Ansicht und zwei vergrößerten Ansichten eines Ausschnitts im Eckbereich,
- Fig. 13: die Konstruktionseinheit nach Fig. 12A in perspektivischer Ansicht,
- Fig. 14A: eine rechteckförmige Konstruktionseinheit mit in den Eckbereichen angeordneten Montagestücken und diese verbindenden Montageschienen in perspektivischer Ansicht,
- Fig. 14B: ein weiteres Ausführungsbeispiel einer quadratischen Konstruktionseinheit mit in den vier Eckbereichen angeordneten Montagestücken und diese verbindenden Montageschienen und C-Schienen in perspektivischer Ansicht,
- Fig. 15A: ausschnittsweise eine Konstruktionseinheit in perspektivischer Ansicht mit einem Montagestück und daran angebrachten Montageschienen in perspektivischer Ansicht von außen,
- Fig. 15B: ausschnittsweise eine Konstruktionseinheit mit einem Montagestück und daran angebrachten C-Schienen in perspektivischer Ansicht von der Innenseite,
- Fig. 16A und 16B: eine Explosionsdarstellung eines Eckbereichs mit einem Montagestück und Blenden in verkleinerter und vergrößerter Ansicht,
- Fig. 17A bis 17C: eine Eckblende in verschiedenen perspektivischen Ansichten,
- Fig. 17D bis 17F: weitere Ansichten der Eckblende,
- Fig. 18A: eine perspektivische Ansicht einer Seitenblende,
- Fig. 18B: die Seitenblende nach Fig. 18A in stirnseitiger Ansicht,
- Fig. 19A: einen Eckbereich einer Konstruktionseinheit wie z. B. Sockel teilweise in Explosionsdarstellung mit einem Montagestück, daran angebrachten C-Schienen und Montageschienen sowie entfernten Blenden,
- Fig. 19B: eine quadratische Konstruktionseinheit, beispielsweise einen Sockel, mit in den vier Eckbereichen angeordneten Montagestücken, diese verbindenden und daran angebrachten Montageschienen, C-Schienen sowie Blenden,
- Fig. 20: einen Eckbereich einer weiteren Konstruktionseinheit mit einem Montagestück, daran angebrachten verschiedenen Montageschienen sowie einer daran angebrachten C-Schiene,
- Fig. 21: einen Ausschnitt aus zwei aneinander gereihten Konstruktionseinheiten mit zwei Montagestücken, einer diese verbindenden Montageschiene sowie einer an einem Eckstück angebrachten weiteren Montageschiene sowie einer angebrachten C-Schiene,
- Fig. 22A und 22B: verschiedene an einem Montagestück anbringbare Adapterelemente mit verschiedenen Adapterplatten,
- Fig. 22C: einen Ausschnitt eines Rahmengestells eines Schaltschranks mit einer darunter angebrachten Rolleneinheit sowie links daneben einen Querschnitt eines vertikalen Rahmenprofils,
- Fig. 22D: ein Beispiel für eine Aufnahmeeinheit z. B. einer Rolleneinheit,
- Fig. 23: zwei in z-Richtung bzw. Höhenrichtung aneinander gereihte und miteinander verbundene Montagestücke,
- Fig. 24A: einen unteren Abschnitt eines auf einem Sockel mit Montagestücken angeordneten Rahmengestells eines Schaltschranks oder Racks in perspektivischer Ansicht,
- Fig. 24B: eine seitliche Ansicht des auf dem Sockel angebrachten Abschnitts des Rahmengestells nach Fig. 24A,
- Fig. 24C: eine Draufsicht des auf einem Sockel angebrachten Rahmengestellabschnitts nach Fig. 24A,
- Fig. 24D: einen Ausschnitt eines Eckbereichs mit Rahmengestell im Sockelbereich nach Fig. 24B,
- Fig. 24E: einen Ausschnitt eines Eckbereichs mit Rahmengestell im Sockelbereich nach Fig. 24D,
- Fig. 25: eine perspektivische Darstellung eines Ausschnitts eines auf einem Sockel angebrachten Rahmengestells, teilweise in perspektivischer Ansicht,
- Fig. 26: einen Ausschnitt zweier aneinander angereihter Sockel mit darauf aufgebrachten aneinander gereihten Rahmengestellen, teilweise in perspektivischer Ansicht,
- Fig. 27A: einen Eckbereich eines Sockels mit Montagestück, einer Eckblende und zwei Seitenblenden in schematischer Darstellung in perspektivischer Ansicht,
- Fig. 27B: einen weiteren Eckbereich eines Sockels mit darauf angebrachtem Schaltschrank mit Beplankungsteil und Sockelblenden in perspektivischer schematischer Ansicht,
- Fig. 27C: eine Eckblende in Draufsicht,
- Fig. 28: einen Ausschnitt eines mit Seitenteilen versehenen Schaltschranks und eines mit Blenden versehenen Sockels in perspektivischer Ansicht und
- Fig. 29: einen auf einem Sockel aufgebrachten unteren Abschnitt eines Rahmengestells mit darunter eingeführten Hebearmen eines Hubgeräts.

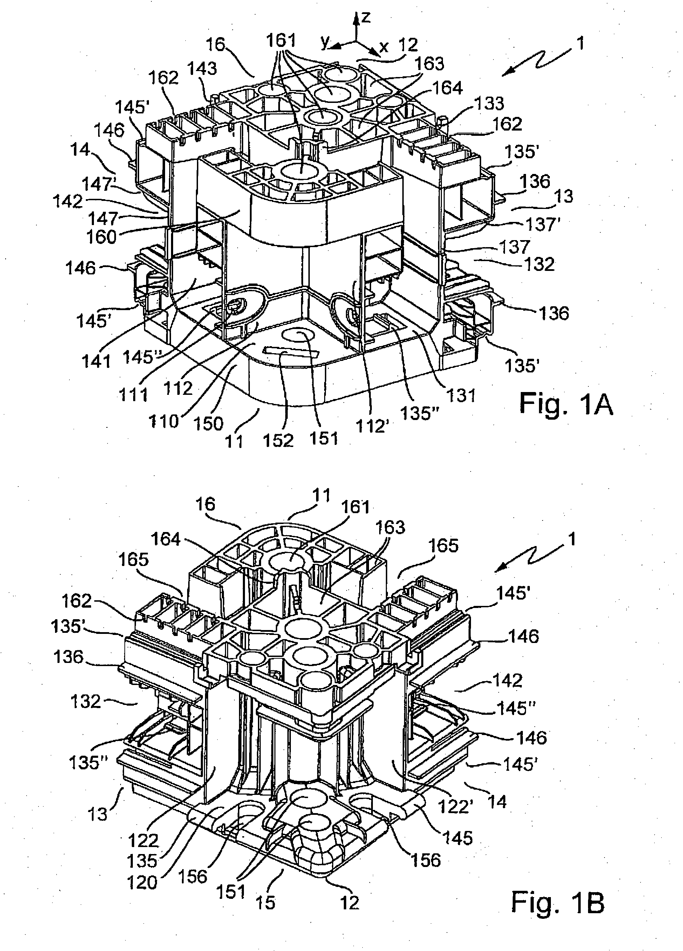

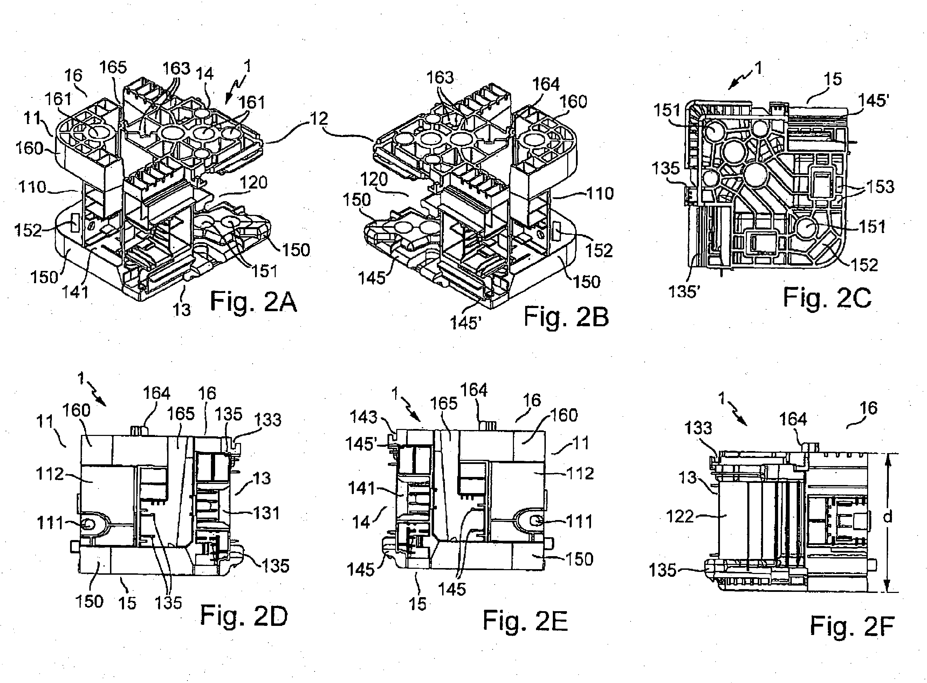

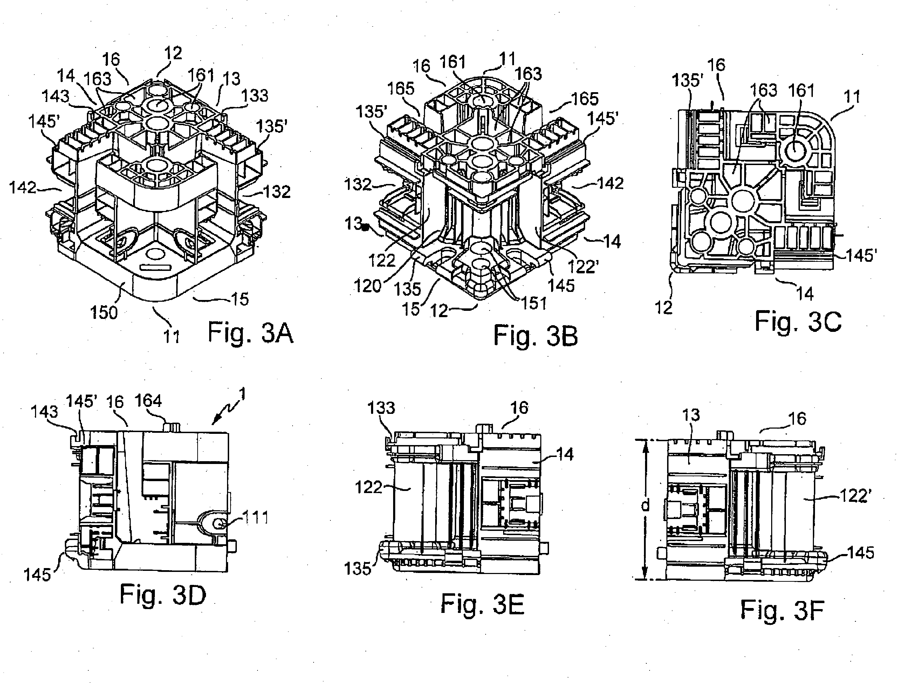

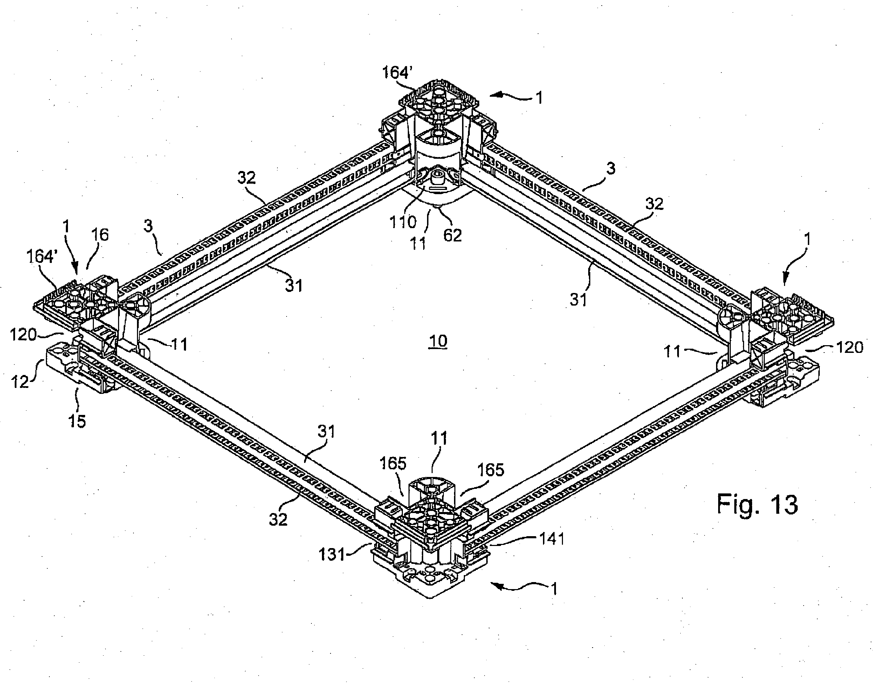

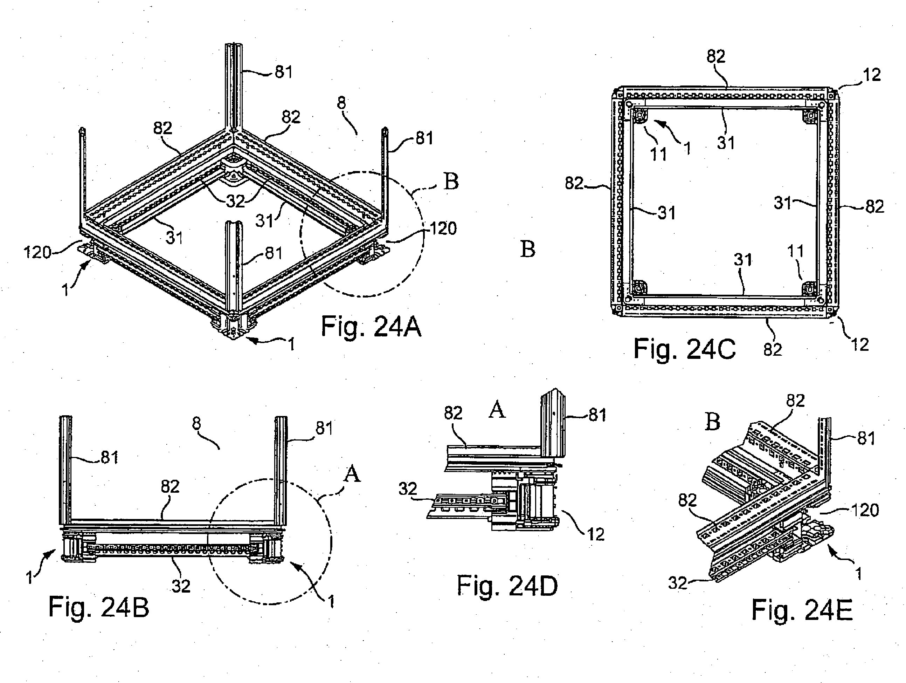

Die Fig. 1A und 1B sowie weiterhin auch die Fig. 2A bis 2F und 3A bis 3F zeigen ein Montagestück 1 in verschiedenen Ansichten. Das Montagestück 1 wird als ein elementares Konstruktionsteil einer Konstruktionseinheit, wie z. B. eines Sockels 10 (vgl. z. B. Fig. 13 und Fig. 24A) oder eines anderen Anbaurahmens, zum Anbau an einem Schaltschrank oder Rack oder einem anderen Gehäuse vorzugsweise als Eckstück in den Eckbereichen der in Draufsicht vorzugsweise rechteckförmigen oder quadratischen Konstruktionseinheit eingesetzt. Die in den Eckbereichen angeordneten Montagestücke 1 werden dabei über längs erstreckte Zwischenelemente, wie Montageschienen 32, im Querschnitt C-förmige Schienen 31 (C-Schienen) und/oder Seitenblenden miteinander verbunden.

Das Montagestück 1 ist als in einem Formungsprozess hergestelltes Formteil ausgebildet, vorzugsweise als Kunststoffformteil oder alternativ als Metallformteil, insbesondere aus einem Nichteisenmetall, beispielsweise aus Aluminium, oder als Formteil aus einem Verbundwerkstoff mit künstlichem und/oder aus nachwachsenden Rohstoffen bestehendem Fasermaterial, das z. B. in einer Kunststoffmatrix eingebettet ist. Es besitzt eine blockartige, grob quaderförmige oder würfelförmige Gestalt mit in den drei rechtwinklig zueinander gerichteten Raumrichtungen x, y, z, gerichteten Seitenteilen wie aus Fig. 1A ersichtlich.

Vorzugsweise ist dabei das Verhältnis jeweils zweier Paare von Ausdehnungen in x-, y-, z-Richtung höchstens 2:1, allenfalls 3:1, wobei die kleinste Abmessung in einer der drei Raumrichtungen mindestens 5 cm und die größte höchstens 20 cm bemisst. Bei einer Konstruktionseinheit des vorstehend genannten Aufbaus mit Montagestücken 1 ist die z-Richtung des Montagestücks 1 senkrecht bezüglich der rechteckigen bzw. quadratischen Ausdehnungsebene der Konstruktionseinheit ausgerichtet, während die x- und y-Richtung parallel zu (bzw. in) Richtung der Seiten der Konstruktionseinheit verlaufen.

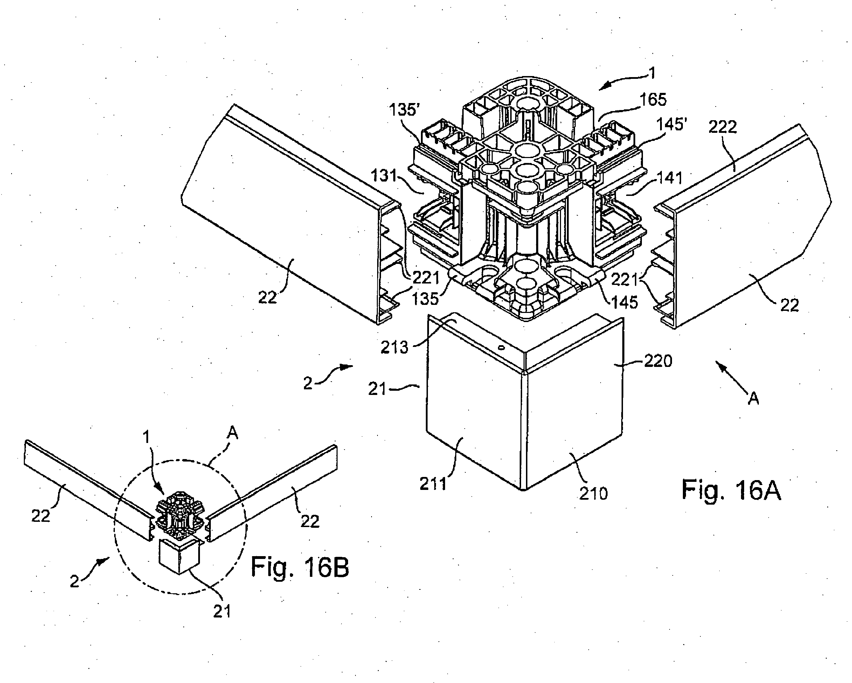

Wie bei dem in den Fig. 1A und 1B sowie auch in den Fig. 2A bis 2F und 3A bis 3F gezeigten Ausführungsbeispiel ersichtlich, ist dieses bezüglich einer in z-Richtung liegenden, vertikalen Diagonalebene, die bezüglich eines in einer Konstruktionseinheit eingebauten Zustandes von einem äußeren Eckbereich 12 des Montagestückes 1 (nachfolgend auch als erster Eckbereich bezeichnet) zu dem gegenüberliegenden inneren Eckbereich 11 des Montagestückes 1 (nachfolgend auch als zweiter Eckbereich bezeichnet) verläuft, symmetrisch ausgebildet und auf allen Außenseiten mit Aufnahmestrukturen für Montageelemente verschiedener Art versehen, die beispielsweise auch die genannten Schienen 3 mit den C-Schienen 31 und Montageschienen 32 sowie Anordnungen von Blenden 2, insbesondere Seitenblenden 22 und Eckblenden 21 (vgl. z. B. Fig. 16A), umfassen.

Wie aus den Fig. 1A und 1B sowie auch den Fig. 2A bis 2F und 3A bis 3F weiterhin ersichtlich, sind in einer zur x-z-Ebene parallelen bzw. in dieser liegenden ersten Anbauseite 13 und in einer zur y-z-Ebene parallelen bzw. in dieser liegenden zweiten Anbauseite 14 zurückversetzte erste und zweite Aufnahmekammern 132, 142 gebildet, die in x-Richtung bzw. y-Richtung ausgerichtet und zur betreffenden Anbauseite 13 bzw. 14 hin sowie auch auf den voneinander weggerichteten Enden der Anbauseiten 13, 14 stirnseitig offen sind. Durch diese Ausbildung können Endabschnitte von Schienen 3 von der betreffenden Anbauseite 13 bzw. 14 her eingesetzt werden, wodurch auch im zusammengebauten Zustand einer Konstruktionseinheit auch nachträglich noch Schienen 3 oder ähnliche Zwischenelemente ergänzt oder entnommen werden können. Außerdem können über die offenen Stirnseiten Schienen 3 oder dgl. eingeführt bzw. eingesteckt werden, woraus sich z. B. Vorteile bei der anfänglichen Montage einer Konstruktionseinheit ergeben können. In den ersten und zweiten Aufnahmekammern 132, 142 sind außerdem Fixierelemente eingeformt, die erste und zweite Rastvorsprünge 135", 145" umfassen, die vorzugsweise an federnden Zungen angebrachte Rastnasen mit nach außen zur betreffenden Anbauseite hin flachen Rastschrägen und nach innen steilen Rastabsätzen aufweisen, wobei die Rastvorsprünge rechtwinklig zur betreffenden Anbauseite 13, 14 in y-Richtung bzw. x-Richtung zeigen, so dass von der betreffenden Anbauseite 13, 14 her eingesetzte Schienen 3 oder dgl. rastend entgegen ihrer Einsetzrichtung gehalten werden. Die Länge der Rastvorsprünge bis zu den steilen Rastabsätzen ist dabei vorteilhaft an gängige Querschnitte von Schienen 3 oder Abstände bis zu Rändern von darin angeordneten Befestigungslöchern abgestimmt, so dass die Schienen 3 oder dgl. Zwischenelemente positionsgerecht fixiert werden. Die in x-Richtung bzw. y-Richtung sich erstreckende Breite der Rastvorsprünge 135", 145" ist dabei weiterhin vorteilhaft an die Breite betreffender rechteckförmiger oder quadratischer Befestigungslöcher insbesondere einer gängigen Lochreihe 312 angepasst. Im Übrigen sind auch die Abmessungen der Aufnahmekammern 132, 142 vorteilhaft auf die Querschnittskontur der Schienen 3 oder dgl. abgestimmt, so dass sich ein problemloses Einsetzen und ein eindeutiger Sitz ergeben.

Die Aufnahmekammern 132, 142 sind bezüglich der vertikalen Richtung (bzw. z-Richtung) oben und unten von parallel zur x-y-Ebene liegenden Wandabschnitten und parallel zur betreffenden Anbauseite 13 bzw. 14 von einem weiteren Wandabschnitt 137, 147 umgeben, wobei innerhalb der Aufnahmekammer 132, 142 bei dem gezeigten Ausführungsbeispiel zusätzlich noch Verstärkungsrippen eingeformt sind. Die genannten Rastvorsprünge 135", 145" sind z. B. an der zur Anbauseite parallelen Begrenzungswand der betreffenden Aufnahme-kammern 132, 142 angeformt.

Wie z. B. aus Fig. 1A deutlich ersichtlich, sind hinter den zu der betreffenden Anbauseite 13, 14 parallelen Wandabschnitt 137 bzw. 147, der die betreffende Aufnahmekammer 132, 142 rückseitig begrenzt, weitere Aufnahmekammern 131, 141 eingebracht, die rundum bis auf einen nach oben in z-Richtung führenden Spalt 165 mit weiteren Wandabschnitten begrenzt und nur in Richtung der voneinander abgekehrten Enden der Anbauseiten 13, 14 stirnseitig offen sind. In diese weiteren Aufnahmekammern können ebenfalls Schienen 3, wie C-Schienen 31 oder Montageschienen 32 eingesetzt, nämlich durch den Spalt 165 von oben eingeführt oder stirnseitig eingerührt bzw. eingesteckt werden. Auch in diesen Aufnahmekammern 131, 141 befinden sich Verbindungselemente, beispielsweise weitere angeformte federnde Rastvorsprünge 135", 145", die an Querschnittskonturen der Schienen 3 bzw. Abstände zu Lochrändern angepasst sind, um die Schienen 3 oder dgl. zu fixieren. Dabei können die Verbindungselemente weiterhin fixierende und positionierende Rippen aufweisen, die auf Querschnittskonturen der Schienen 3 oder dgl. abgestimmt sind und zusätzlich eine Versteifung von Wandabschnitten ergeben. Des Weiteren können zum Einbringen von weiteren Fixierelementen in von außen zugänglichen Wandabschnitten auch Befestigungslöcher 111 vorgesehen sein. Bei einer (nicht dargestellten) alternativen Ausgestaltung können die weiteren Aufnahmekammern 131, 141 oder zusätzliche Aufnahmekammern auch von der von den Anbauseiten beabstandeten Innenseiten her offen und zugänglich sein.

Des Weiteren umfassen die Aufnahmestrukturen auf den Anbauseiten 13, 14 weitere Nuten 133, 143, weitere Rastvorsprünge 135, 145 bzw. 135', 145', wobei letztere sich entlang der betreffenden Anbauseiten 13, 14 in x-Richtung bzw. y-Richtung erstrecken und an leistenartigen Anformungen außen auf den Anbauseiten 13, 14 ausgebildete längs verlaufende Nuten aufweisen, wobei Nutpaare mit in z-Richtung nach oben geöffneten Nuten und nach unten geöffneten Nuten auf der jeweiligen Anbauseite 13 bzw. 14 gebildet sind, die vorzugsweise in derselben zur x-z-Ebene bzw. y-z-Ebene parallelen Ebene liegen, In diesen Nutpaaren können gegeneinander gerichtete Rastnasen an z. B. auf den Seitenblenden 22 oder Eckblenden 21 angeformten federnden Rastvorsprüngen eingeschnappt werden. Ferner sind außen auf den Anbauseiten weitere zapfenartige Rastvorsprünge 135, 145 mit nach unten zeigenden Rastnasen angeformt. Auch sind auf den Anbauseiten 13, 14 in x-Richtung bzw. y-Richtung verlaufende stegartige Rippen 136, 146 angeformt, die zur Positionierung von Blenden 2 und/oder zur Versteifung dienen. Auch dienen die die Aufnahmekammern 131, 132 bzw. 141, 142 umgrenzenden Wandschnitte 137, 137' neben der Positionierung zur Versteifung des Montagestücks 1.

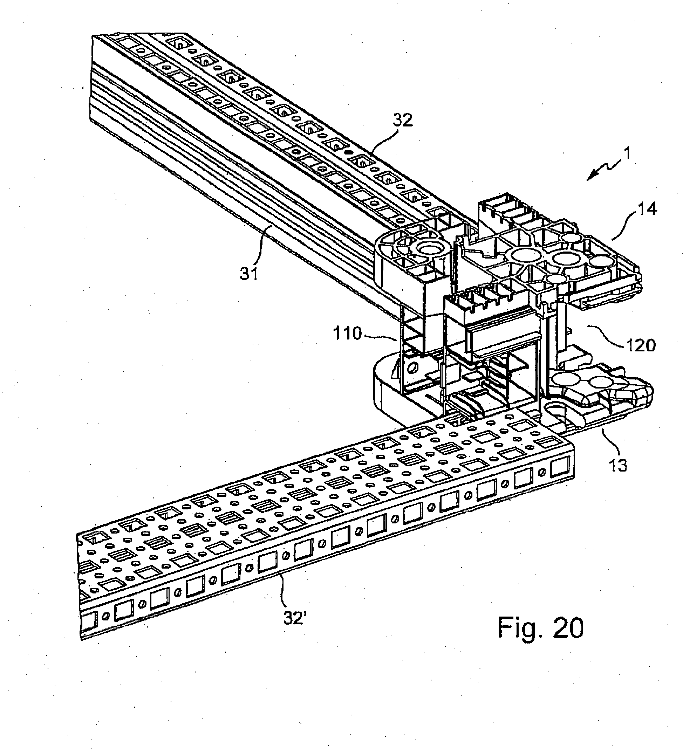

In z-Richtung ist das Montagestück 1 von einer ersten (im Einbauzustand unteren) Grundseite 15 und einer zweiten (im Einbauzustand oberen) Grundseite 16 begrenzt, die die Außenseite eines ersten bzw. zweiten Grundwandabschnitts 150, 160 bilden und sich in zur x-y-Ebene parallelen Ebenen erstrecken. In den Grundwandabschnitten sind senkrecht (in z-Richtung) zur jeweiligen Grundseite 15, 16 nach außen offene kammerartige Hohlräume 153 (vgl. dazu auch Fig. 20) und 163 ausgebildet, die von sie vollständig oder teilweise umgrenzenden (im Vergleich zur lichten Öffnungsweite) dünnen Wandabschnitten umgeben sind. Ferner münden in der zweiten oberen Grundseite 16 die mit den Aufnahmekammern 131, 141 verbundenen Spalte 165. Darüber hinaus sind in den beiden Grundseiten 15, in dem gezeigten Ausführungsbeispiel entlang der Diagonalen von dem ersten zu dem zweiten Eckbereich 12, 11 sowie daneben liegend in z-Richtung verlaufende zylindrische Löcher bzw. Bohrungen eingeformt, wobei zumindest einige der zylindrischen Bohrungen 151, 161 in den beiden Grundwandabschnitten miteinander fluchten. Wie Fig. 1A zeigt, ist in dem zweiten Eckbereich 11 in dem ersten Grundwandabschnitt 150 ein quer zur Diagonalen zwischen den beiden Eckbereichen 11, 12 angeordneter Schlitz 152 eingeformt. Weitere schlitzartige Strukturen 162 sind in der Außenseite des zweiten Grundwandabschnitts 160 eingeformt. Ferner können auf den Grundseiten 15, 16, insbesondere auf der oberen Grundseite 16, nach außen in z-Richtung vortretende Strukturen, wie der Vorsprung 164 oder in x-Richtung und y-Richtung verlaufende stegartige Vorsprünge 164' (vgl. Fig. 13) angeformt sein, um auf der Oberseite des Montagestückes 1 anzubringende Konstruktionsteile, wie z, B. Abschnitte eines Rahmengestells, eine Sockelabdeckung oder Adapterplatten eindeutig zu positionieren. Zur Positionierung können im Übrigen aber auch die genannten Hohlräume 163 bzw. 153 und Bohrungen 161, 151 genutzt werden.

Wie die Fig. 1A und 1B sowie auch die Fig. 2A bis 2F und 3a bis 3F weiterhin zeigen, sind in den Eckbereichen 11, 12 freie Eckräume 110 bzw. 120 gebildet. In diesen können weitere Montageelemente bei freier Zugänglichkeit von außen eingesetzt werden, wobei der bezüglich einer Konstruktionseinheit außen liegende Eckraum mittels Blenden 2, insbesondere einer Eckblende 21 abgedeckt werden kann. Die Eckblende lässt sich z. B. mittels auf deren Innenseite angeformter, entsprechend positionierter federnder Rastelemente mit einführseitigen Rastschrägen und entgegen der Einführrichtung wirkenden steilen Rastabsätzen an den Rastvorsprüngen 135, 145 einerseits und den nach oben offenen Nuten 133, 143 andererseits fixieren.

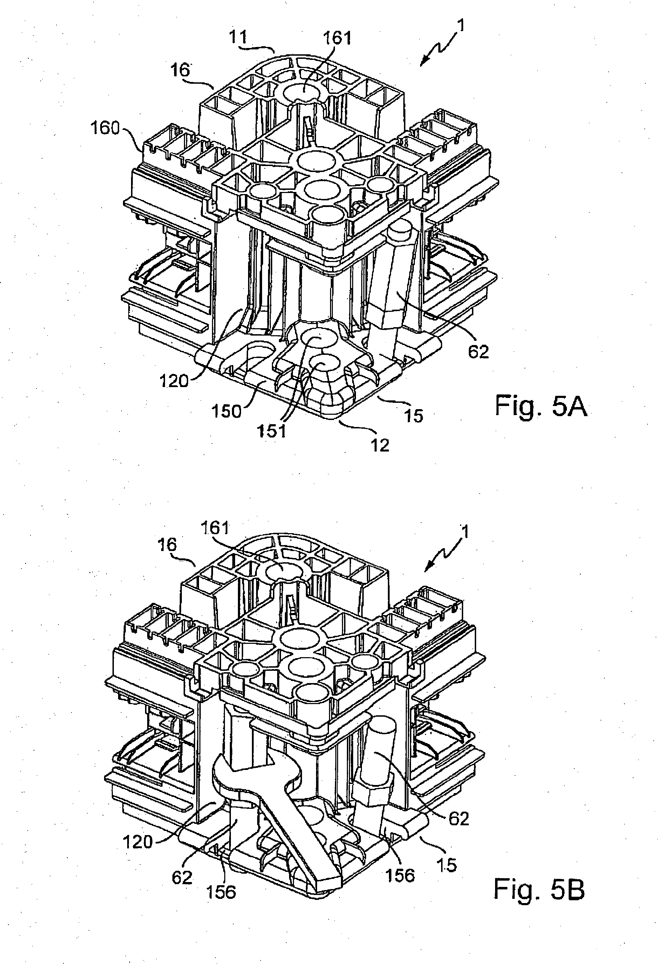

Der erste bzw. äußere Eckbereich 12 ist dabei dadurch gebildet, dass die Anbauseiten 13, 14 an ihren einander zugekehrten Enden voneinander beabstandet sind und in dem betreffenden ersten (insoweit gedachten) Eckbereich 12 des Montagestücks 1 den freien Eckraum bilden. Dabei ist der erste Eckraum 120 von den beiderseitigen Aufnahmekammern 132, 142 mittels einer jeweiligen Eckbereichsbegrenzungswand 122, 122' getrennt, wobei die Eckbereichsbegrenzungswände 122, 122' rechtwinklig zu der betreffenden Anbauseite 13, 14 und in z-Richtung gerichtet sind. In z-Richtung ist der erste Eckraum 120 von dem ersten und dem zweiten Grundwandabschnitt 150, 160 begrenzt. Dabei fluchten die in den den ersten Eckraum 120 begrenzenden Grundwandabschnitten angeordneten Bohrungen 151, 161 miteinander. Ferner sind in der dem ersten Eckraum zugewandten Seite des unteren Grundwandabschnitts 150 von den seitlich von der Diagonale angeordneten Bohrungen zur jeweiligen Anbauseite 13, 14 hin offene Ausnehmungen 156 eingebracht, wodurch die betreffenden Bohrungen 151 zum Einsetzen von Montageelementen besser zugänglich sind, wie die Fig. 5A und 5B zeigen, wobei in die miteinander fluchtenden Bohrungen des ersten und des zweiten Grundwandabschnitts 150, 160 als Montageelement eine verstellbare Nivelliereinheit 62 eingesetzt ist. Die beiden Grundwandabschnitte 150, 160 bilden dabei an ihren Außenrändern definierte Anlageränder für eine Blende, insbesondere die Eckblende 21, wobei dort ein definierter Eckbereich ausgebildet ist.

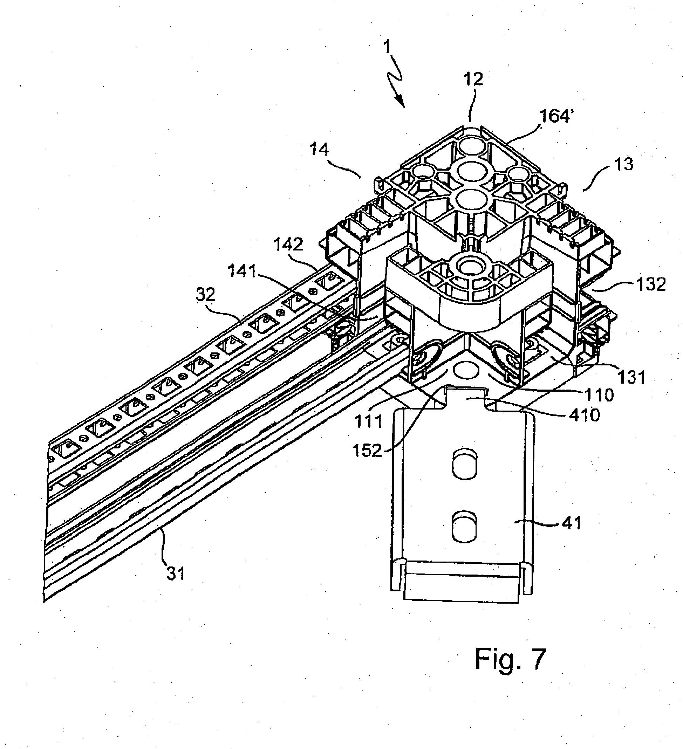

Der zweite Eckraum 110 in dem (insoweit gedachten) zweiten Eckbereich 11 ist dadurch gebildet, dass sich auf den Innenseiten der voneinander weggerichteten Enden der ersten und der zweiten Anbauseite 13, 14 weitere Wandbereiche einstöckig anschließen. Wie z. B, die Fig. 1A zeigt, sind in diesen Bereichen die bereits beschriebenen Aufnahmekammern 131, 141 angeordnet, wobei u. a. in der Tiefe der Aufnahmekammern nach innen ragende Wandbereiche vorhanden sind. Zwischen den Wandbereichen ist auf deren einander zugekehrten Enden der zweite Eckraum 110 als Freiraum ausgebildet. Dieser ist seitlich mittels parallel zu den benachbarten Anbauseiten 13, 14 und in z-Richtung ausgerichteter zweiter Eckbereichsbegrenzungswände 112, 112' und in z-Richtung mittels des ersten und des zweiten Grundwandabschnitts 150, 160 begrenzt, wobei in den Eckbereichsbegrenzungswänden 112, 112' Befestigungslöcher 111 zu den Aufnahmekammern 131, 141 und in der zu dem zweiten Eckraum 110 liegenden Seite des ersten Grundwandabschnitts 150 der Schlitz 152 eingebracht sind, in den eine Verankerungsklaue 41 mit einer abgewinkelten flachen Haltenase 410 (vgl. Fig. 7) zum Verankern einer aufgebauten Konstruktionseinheit an einem Untergrund einsetzbar ist. In dem zweiten Eckbereich 11 sind die bezüglich einer Konstruktionseinheit nach innen liegenden Bereiche der beiden Grundwandabschnitte 150, 160 abgerundet, (so dass insoweit eine mathematisch exakte Ecke nur gedacht ist). Auch der zweite, innere Eckraum 110 bietet vorteilhafte Montagemöglichkeiten und ist z. B. vom Innenraum eines Schaltschranks aus nach Abnahme einer Bodenplatte, die gegebenenfalls einen Sockel abdeckt, leicht zugänglich. Auch nach Abnahme einer Seitenblende wird ein Zugang geschaffen. Der zweite Eckraum 110 kann alternativ auch mittels schräg zur x-y-Richtung und in z-Richtung verlaufenden Wandabschnitten oder nur einem schrägen Wandabschnitt gebildet werden.

Mittels der bis über die Eckräume 11, 12 ausgedehnten Grundwandabschnitte 150, 160 werden auf deren Außenseite bzw. Grundseite 15, 16 große Aufnahmebereiche für beiderseitige Anbauten in z-Richtung bzw. eine Abstützung auf einer Unterlage erhalten. Die Hohlräume 153, 163 und Bohrungen 151, 161 mit ihren jeweiligen relativ dünnen Wandabschnitten ergeben stabile Abstützstrukturen insbesondere in z-Richtung nach Art einer Wabenstruktur, wobei jedoch die zellenartigen Hohlräume nicht alle gleich ausgebildet sind, sondern als unterschiedlich gestaltete Funktionsbereiche mit den Aufnahmestrukturen genutzt werden können einschließlich der die Eckräume 110, 120 überragenden Bereiche der Grundwandabschnitte 150, 160. in dem zentralen Bereich zwischen den Eckräumen 110, 120 bilden die die Hohlräume 153, 163 bzw. Bohrungen 151, 161 umgebenden Wandbereiche gegebenenfalls zwischen den beiden Grundseiten 15, 16 sich durchgehend erstreckende oder an parallel zu den Grundseiten 15, 16 ausgedehnten Wandabschnitten abgestützte Stützstrukturen in z-Richtung. In x--Richtung und y-Richtung verlaufende Wandabschnitte sind ebenfalls relativ dünn ausgebildet und ergeben gegebenenfalls zusammen mit Versteifungsrippen auch in x-Richtung und y-Richtung hohe Stabilität bei relativ geringem Materialeinsatz und damit relativ leichtem Aufbau des Montagestücks. Insbesondere bei Ausbildung als Kunststoffformteil ist neben relativ dünnen Wandabschnitten auch darauf geachtet, dass Übergangsbereiche, wie Kreuzungs- und Eckbereiche zwischen den Wandabschnitten möglichst geringe Materialvolumina umfassen, wodurch der Formungsprozess bei hoher Maßhaltigkeit begünstigt wird. Die genannten Strukturen und Materialien, insbesondere Kunststoff oder Verbundwerkstoff, des Montagestücks 1 ergeben auch Vorteile bei der Schwingungsisolation hinsichtlich Schwingungs- und Dämpfungseigenschaften.

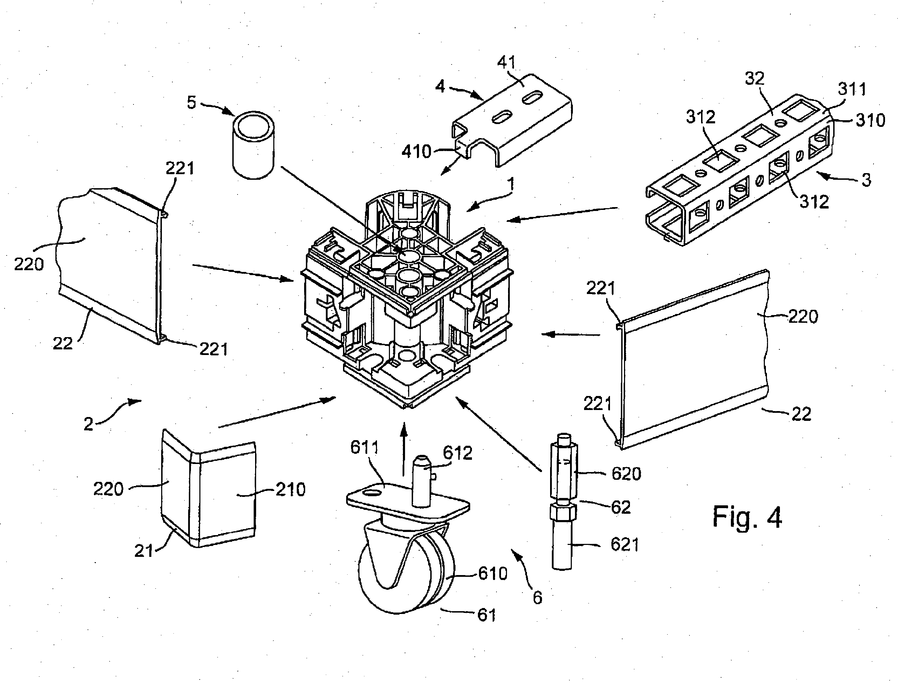

Wie Fig. 4 zeigt, können an den Montagestücken 1 in unterschiedlicher Kombination gleiche oder verschiedene Montageelemente angebracht werden, wobei Fig. 4 Blenden 2, nämlich eine Eckblende 21 mit einem ersten und einem zweiten Schenkel sowie Seitenblenden 22 mit einer Blendenwand 220 und auf deren dem Montagestück 1 zugekehrter Innenseite angeformten Blendenbefestigungselementen 221, Schienen 3, nämlich eine Montageschiene 32 mit Basisschenkel 310, daran rechtwinklig abgewinkelten Seitenschenkeln 311, die ihrerseits mit abgewinkelten freien Endabschnitten versehen sind und in dem Basisschenkel 310 und den Seitenschenkeln 311 angeordneten Lochreihen 312, ein Verankerungsmittel 4, nämlich eine Verankerungsklaue 41 mit einer daran abgewinkelten stirnseitigen flachen Haltenase 410, Stützmittel 6, nämlich eine Rolleneinheit 61 mit Rolle 610, Stützplatte 611 und Halteglied 612, eine Nivelliereinheit mit Nivellierhülse 620 und Nivellierbolzen 621 sowie einen zylinderförmigen Gewindeeinsatz 5 zeigt, der in eine betreffende, angepasste Bohrung 151, 161 eingesetzt werden kann.

Wie die bereits angesprochenen Fig. 5A und 5B zeigen, kann die Nivelliereinheit 62 mit der Nivellierhülse 620 und dem Nivellierbolzen z. B. in den ersten Eckbereich 12 eingesetzt werden, wenn das Eckstück 1 z. B. zum Aufbau eines Sockels 10 verwendet wird. Die Nivelliereinheit 62 ragt dabei mit einem angepassten oberen Bolzenabschnitt in die in dem oberen Grundwandabschnitt 160 an entsprechender Stelle vorhandene Bohrung und mit dem unteren Abschnitt des Nivellierbolzens 621 in die damit in z-Richtung fluchtende Bohrung 151. Zum einfachen Einsetzen ist auf der Oberseite des unteren Grundwandabschnitts 150 die zu der betreffenden Anbauseite 13, 14 hin offene Ausnehmung 156 vorgesehen. Die Nivellierhülse 620 stützt sich dabei mit ihrer bundartigen Oberseite an dem die Bohrung 161 umgebenden Bereich des Grundwandabschnitts 160 ab, während der Nivellierbolzen 621 mit seinem unteren Endabschnitt die betreffende Bohrung 151 nach unten durchragt und mehr oder weniger weit mittels eines an einem Sechskantabschnitt der Nivelliereinheit 62 angesetzten Werkzeugs heraus- oder hineingedreht werden kann.

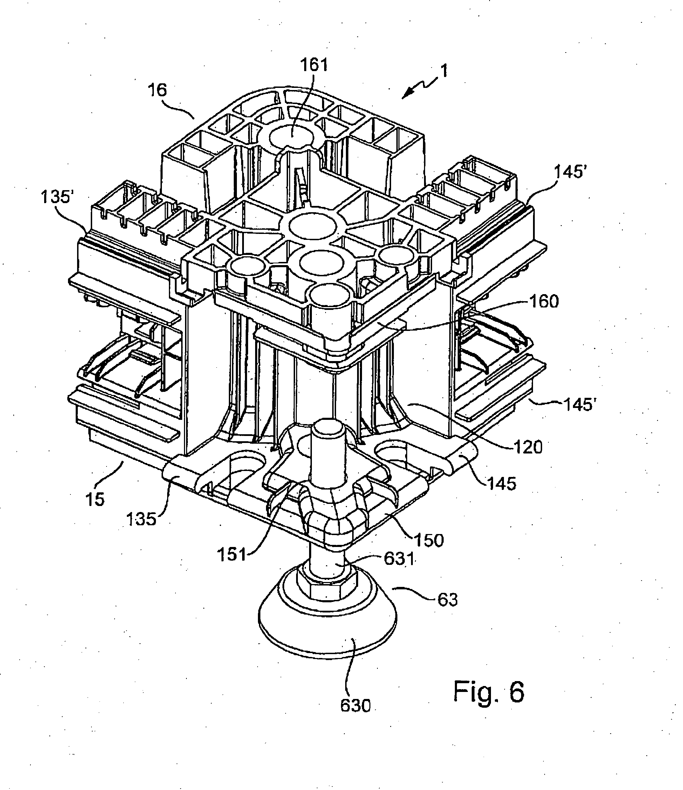

Fig. 6 zeigt einen als Stützmittel 6 in dem ersten Eckbereich 12 eingesetzten Stützfuß 63 mit einer Fußplatte und einem eine betreffende Bohrung 151 durchragenden Fußzapfen 631.

Fig. 7 zeigt einen Eckbereich einer zum Teil montierten Konstruktionseinheit, beispielsweise eines Sockels 10, mit einem Montagestück 1, daran über Aufnahmekammern 141, 142 angebundenen Schienen 3, nämlich einer C-Schiene 31 und einer Montageschiene 32, sowie mit einem Verankerungsmittel 4 in Form einer Verankerungsklaue 41, die mit einer abgewinkelten flachen Haltenase 410 in den in Größe und Form weitgehend angepassten Schlitz 152 in dem unteren Grundwandabschnitt 150 im inneren Eckbereich 11 eingreift. Eine derartige Konstruktionseinheit wie Sockel 10 oder Anbaurahmen, bietet Vorteile zum Einbau von elektrischen Komponenten und/oder Klimatisierungskomponenten oder Energiespeicherkomponenten, z. B. zum Befestigen derselben gegebenenfalls über Haltestreben, die an den Montageschienen 32 einfach montiert werden können.

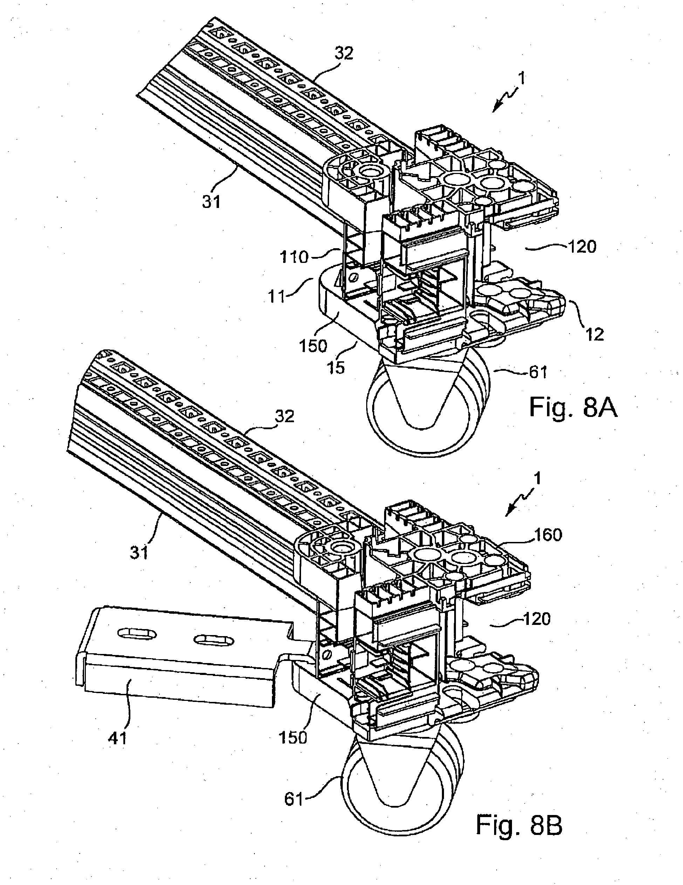

Auch bei den in den Fig. 8A und 8B ausschnittsweise gezeigten, teilmontierten Konstruktionseinheiten sind an dem Montagestück 1 eine C-Schiene 31 und eine Montageschiene 32 angekoppelt. Unter dem Montagestück 1 ist eine Rolleneinheit 61 montiert. Zudem ist in Fig. 8B auch eine an dem Montagestück 1 eingesetzte Verankerungsklaue 41 dargestellt.

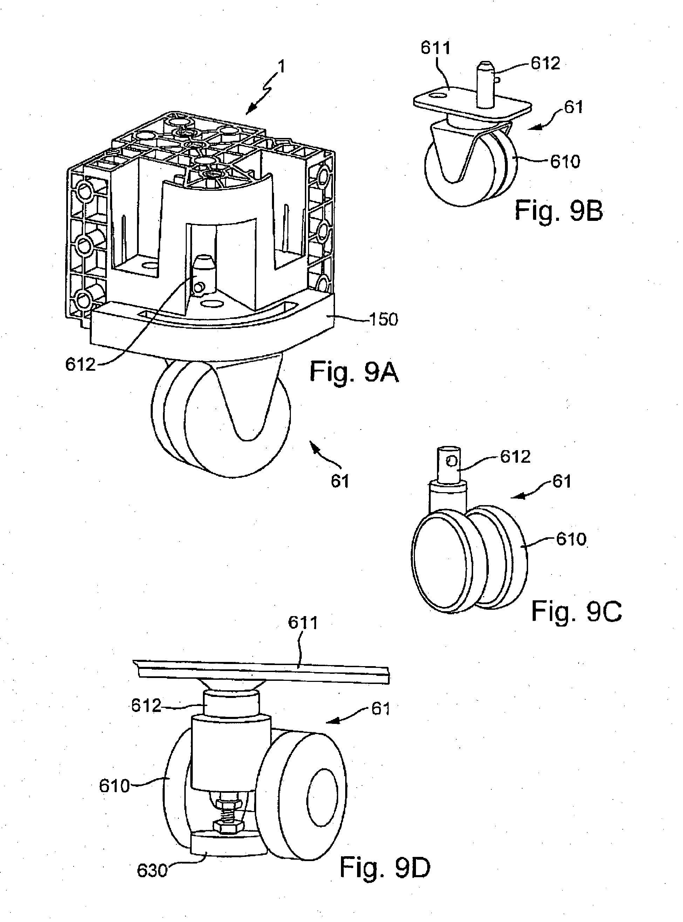

Die Fig. 9A bis 9D zeigen verschiedene Ausführungsformen von Rolleneinheiten 61, wobei in Fig. 9A eine an einem Montagestück 1 montierte Rolleneinheit 61 dargestellt ist. Dabei durchragt die Rolleneinheit 61 mit einem bolzenförmigen Halteglied 612 eine Bohrung 151 in dem unteren Grundwandabschnitt 150 im inneren Eckbereich 110. Das Halteglied weist hierbei eine Art Bajonettverbindung auf, wobei die Bohrung 151 zum Durchführen eines überstehenden Querbolzens entsprechend angepasst ist. Fig. 9B zeigt eine entsprechend ausgebildete Rolleneinheit 61 mit Stützplatte 611 und Halteglied 612 mit Bajonettbefestigung. Fig. 9C zeigt eine Rolleneinheit mit Bajonettbefestigung ohne Stützplatte und Fig. 9D eine Rolleneinheit mit zusätzlichem Nivellierfuß mit Fußplatte 630.

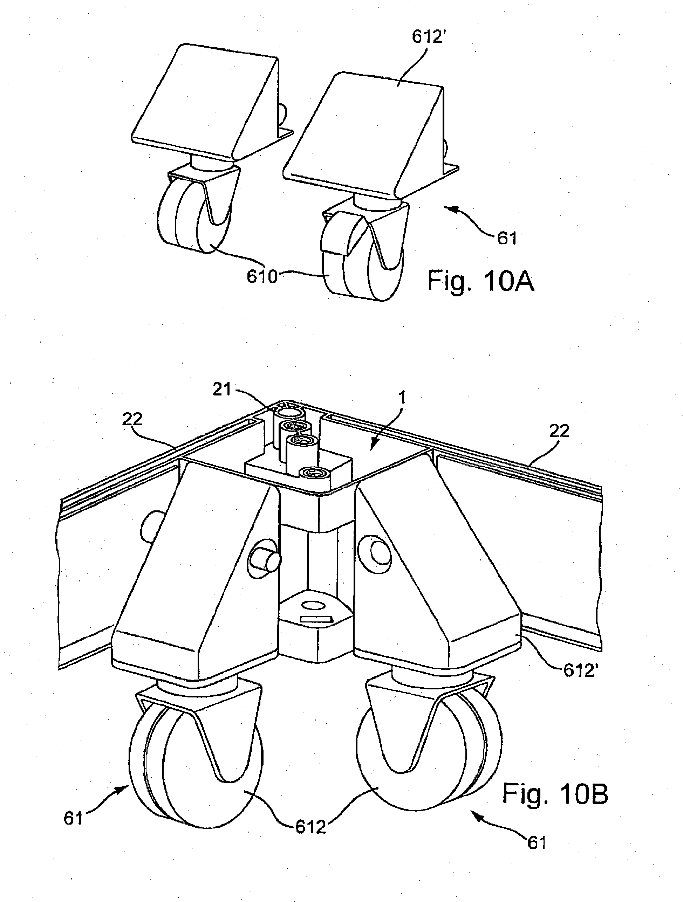

In den Fig. 10A und 10B sind alternative Ausführungsbeispiele für Rolleneinheiten 61 gezeigt, wobei diese mit blockartigen Haltegliedern 612' seitlich an den in den zweiten Eckbereich 11 übergehenden Wandbereichen des Montagestücks 1 ansetzbar und befestigbar sind.

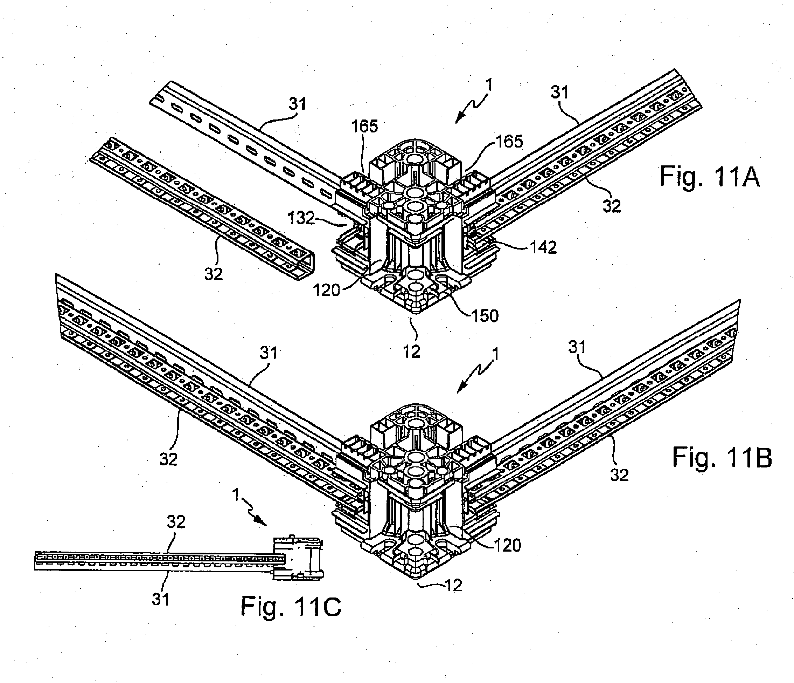

In den Fig. 11A und 11B sind weitere Ausschnitte eines Eckbereichs einer teilweisen montierten Konstruktionseinheit, beispielsweise eines Sockels dargestellt, wobei an beiden Anbauseiten 13, 14 Schienen 3, nämlich C-Schienen 31 und Montageschienen 32 angebracht bzw. anzubringen sind. Fig. 11C zeigt eine betreffende seitliche Ansicht. Wie aus den Fig. hervorgeht, kann die Montageschiene 32 auch nachträglich einfach in die betreffende Aufnahmekammer 132 bzw. 142 des Montagestücks 1 eingefügt werden, nachdem eine gegebenenfalls vorhandene Blende abgenommen ist. Die Montageschiene 32 verrastet an dem federnden Rastvorsprung 135" bzw. 145".

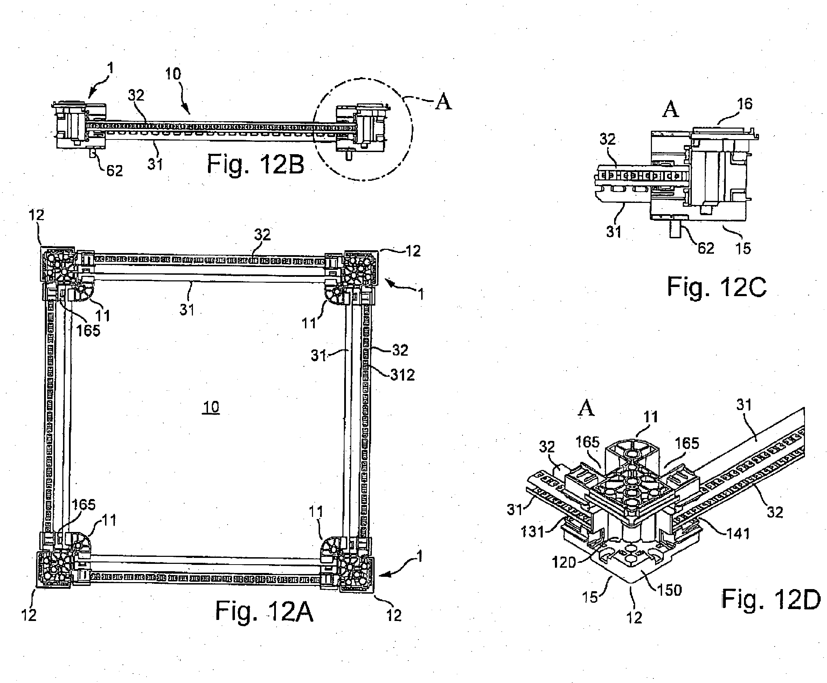

Fig. 12A zeigt eine in Draufsicht quadratische Konstruktionseinheit, beispielhaft einen Sockel 10, mit in den vier Eckbereichen angeordneten Montagestücken 1 sowie diese verbindenden Zwischenelementen in Form von C-Schienen 31 und Montageschienen 32, die in der vorstehend angegebenen Weise mit ihren Endabschnitten an den Eckstücken 1 angekoppelt sind. Fig. 12B zeigt den Sockel 10 von einer Seite, während die Fig. 12C und 12D Ausschnitte der Eckbereiche des Sockels 12 in vergrößerter Darstellung wiedergeben. Beispielsweise können die relativ schmal ausgebildeten C-Schienen 31 mit ihren Schmalseiten von oben in die Spalte 165 eingeführt und dann in den betreffenden Aufnahmekammern 131 gegebenenfalls nach seitlicher Verschiebung nach innen hin fixiert werden, wobei sie auf ihrer einen Seite von den betreffenden Rastvorsprüngen 135" hintergriffen und fixiert werden (vgl. auch z. B. Fig. 1A). Die C-Schienen können in dem Sockelbereich eines Schaltschranks vorteilhaft zur Abfangung von Leitungen, wie z. B. elektrischen Kabeln verwendet werden. Die Lochreihen 312 mit quadratischen oder rechteckförmigen Löchern in definiertem Rasterabstand und gegebenenfalls dazwischen liegenden runden Löchern werden dabei vorteilhaft zu entsprechenden Löchern bzw. Lochreihen von Montageschienen oder Rahmenprofilen des Schaltschranks bzw. dessen Rahmengestells fluchtend ausgerichtet. Wie Fig. 12D erkennen lässt, ist der außen liegende zweite Eckbereich 120 von vom und von der Seite frei zugänglich, nachdem gegebenenfalls abdeckende Blendenelemente abgenommen sind.

Eine entsprechende Konstruktionseinheit, beispielsweise einen Sockel 10, wie die Fig. 12A, zeigt auch die Fig. 13, jedoch in perspektivischer Draufsicht. Auf der oberen Außenseite ist eine vorliegend quadratische Auflagefläche mit Aufnahmestrukturen gebildet, wobei im äußeren Randbereich in x-Richtung und y-Richtung verlaufende leistenartige Vorsprünge 164' auf dem oberen Grundwandabschnitt 160 angeformt sind. In den inneren Eckräumen 110 sind Verstellschrauben oder Verbindungsschrauben in betreffenden Bohrungen 151 eingesetzt, wie der in der Fig. hintere (auf dem Blatt oben) dargestellte Eckraum 110 erkennen lässt.

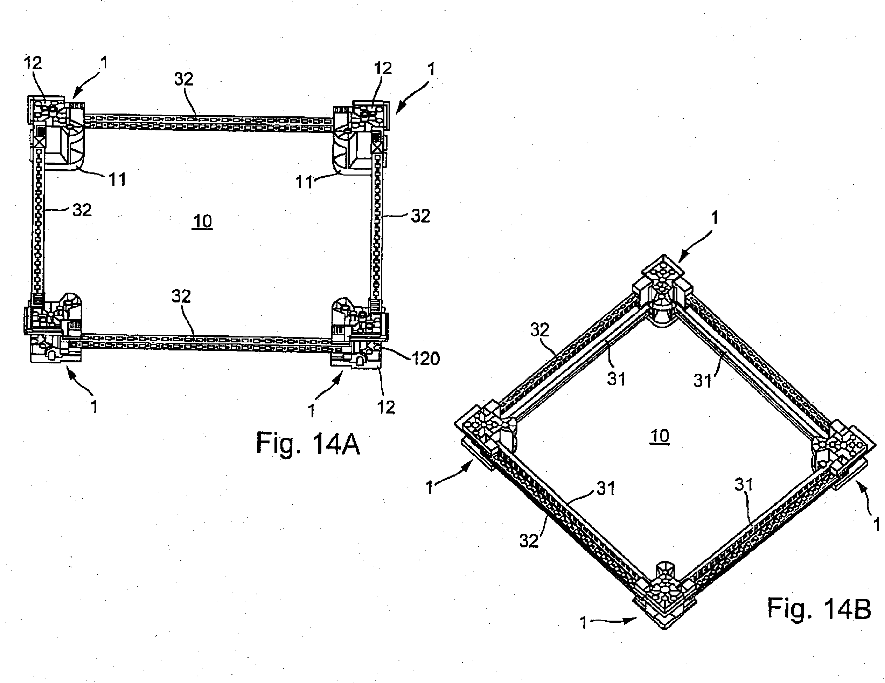

Die Fig. 14A und 14B zeigen weitere Ausführungsbeispiele für Konstruktionseinheiten in Form von teilweise montierten Sockeln 10. In Fig. 14A ist ein rechteckförmiger Sockel mit Montageschienen 32 als Verbindungselemente gezeigt, während Fig. 148 einen quadratischen Sockel 10 mit Montageschienen 32 und C-Schienen 31 als Zwischenelemente bzw. Verbindungselemente zeigt. In den Ecken sind auch hierbei jeweils Eckstücke 1 in der vorstehend beschriebenen Ausbildung angeordnet.

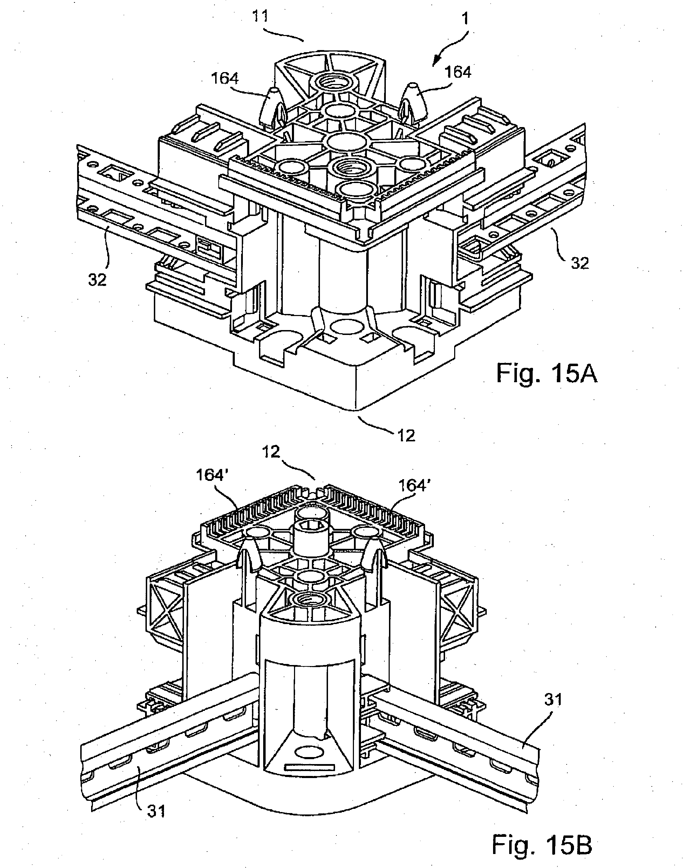

Die Fig. 15A und 15B zeigen wiederum Eckbereiche einer Konstruktionseinheit mit daran angekoppelten Montageschienen 32 bzw. C-Schienen 31 in einige Bohrungen 161 sind dabei Gewindeeinsätze aus Metall eingesetzt. In einer zentralen Bohrung 161 ist, wie Fig. 15B zeigt, eine Imbusschraube eingebracht. Mit solchen Maßnahmen kann auf der Oberseite des Montagestücks ein Anbau z. B. eines Rahmenabschnitts eines Rahmengestells vorgenommen werden. Die Vorsprünge 164, 164' ergeben definierte Anlagestellen und eine genaue Positionierung.

Die Fig. 16A und 16B zeigen einen Ausschnitt zu einer Anordnung von Blenden 2 an einem Montagestück 1, wobei in Fig. 16A der in Fig. 16B dargestellte Eckbereich vergrößert wiedergegeben ist. Die Blendenanordnung 2 weist zwei Seitenblenden 22, die an den Anbauseiten 13, 14 des Montagestücks 1 angebracht werden, sowie eine Eckblende 21 auf, die im angebrachten Zustand den äußeren Eckraum 120 nach außen abdeckt.

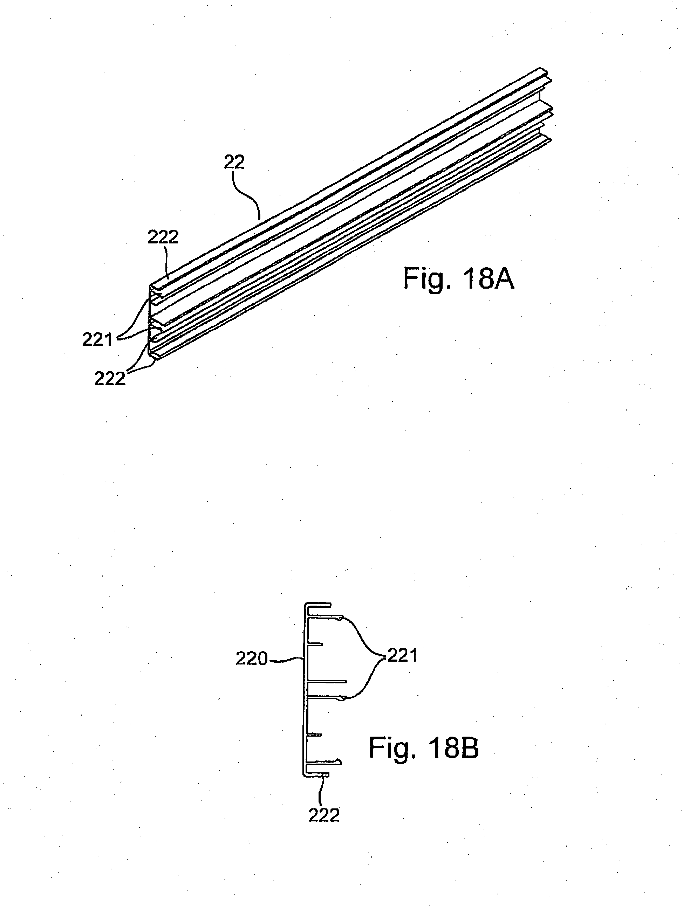

Die Seitenblenden, wie auch die Fig. 18A und 188 zeigen, sind vorteilhaft als Profilabschnitte aus Metall oder vorzugsweise Kunststoff (bzw. auch aus Verbundwerkstoff, wie etwa in eine Kunststoffmatrix eingebettete Fasern aus künstlichem Material oder nachwachsendem Rohstoff) hergestellt, wobei sie eine auf der Außenseite flache Blendenwand 220 aufweisen, auf deren Innenseite Blendenbefestigungselemente 221 bzw. Versteifungsrippen 222 angeformt sind, Die Versteifungsrippen 222 oder die Blendenbefestigungselemente 221 können auch in den Längsrandbereichen der Blendenwand 220 rechtwinklig vorstehen, wie Fig. 16A erkennen lässt. Auch die Blendenbefestigungselemente 221 können als Versteifungselemente dienen, so dass auf weitere gesonderte Versteifungsrippen verzichtet werden kann. Die stegartigen Blendenbefestigungselemente 221 sind an ihren freien Endbereichen mit Rastnasen versehen, die zum freien Ende hin, also in Einführrichtung, flache Einführschrägen und entgegen der Einführrichtung mehr oder weniger steile Rastflanken aufweisen. Die stegartigen Blendenbefestigungselemente 221 bilden dabei vorteilhaft federnde Rastzungen, die gegen ihre elastischen Federkräfte auslenkbar sind. Sie wirken mit an den Anbauseiten 13 bzw. 14 angeordneten Raststrukturen zusammen, an die sie angepasst sind. Hierzu dienen bei dem Ausführungsbeispiel z. B. die in den leistenartigen Rastvorsprüngen 135', 145' eingebrachten Nuten, die nach unten bzw. oben (bezüglich der z-Richtung) offen sind und in die entsprechend gegeneinander gerichtete Rastnasen jeweils zweier Blendenbefestigungselemente 221 rastend einschnappen, Die Versteifungsrippen 222 und an den Anbauseiten 13, 14 vorstehende Stege können dabei zu einer stabilen Abstützung in genau positionierter Lage dienen. Die Fig. 18A und 18B zeigen die Seitenblenden 22 von der Innenseite bzw. von der Stirnseite.

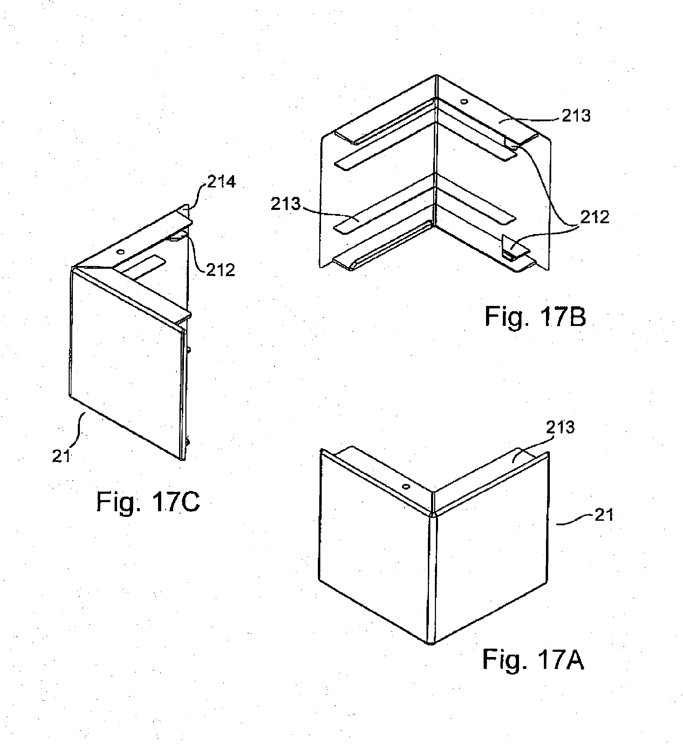

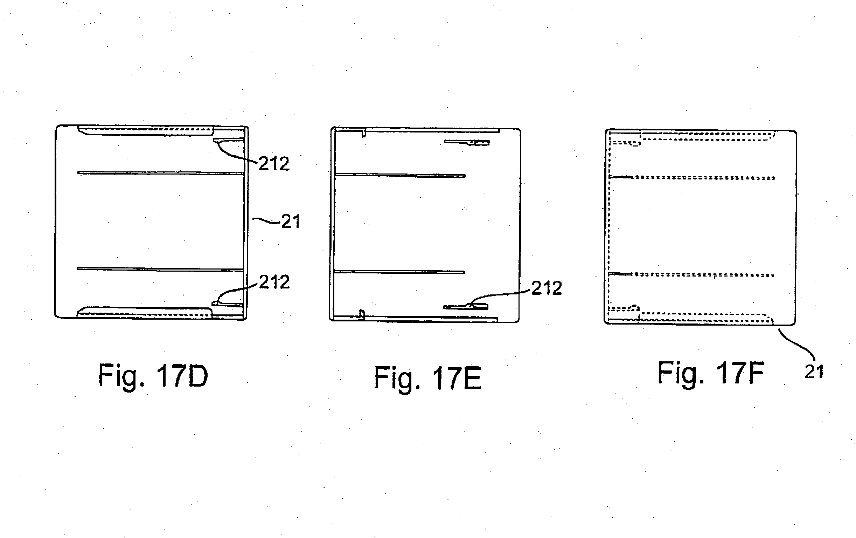

Auch die Eckblende 21 ist vorteilhaft als Formteil aus Metall oder vorzugsweise Kunststoff (oder auch genannten Verbundwerkstoffen) hergestellt. Der erste und der zweite Schenkel 210, 211 ist ebenfalls von einer außen flachen Blendenwand 220 gebildet, die in ihrer Höhe (z-Richtung) im Wesentlichen der Höhe der Seitenblenden 22 entspricht. Auf der Innenseite der Schenkel 210, 211 sind zungenartig oder stegartig vorstehende Eckblendenbefestigungselemente 212 sowie stegartige Versteifungsrippen 213 angeformt, wie insbesondere auch aus den Fig. 17A bis 17F ersichtlich ist. Die Eckblendenbefestigungselemente 212 bilden vorzugsweise an der Blendenwand angeformte federnde Rastvorsprünge mit Rastnasen, wobei zwei in z-Richtung voneinander beabstandete Rastvorsprünge 212 mit ihren Rastnasen gegeneinander gerichtet sind und in entsprechend positionierte Nuten bzw. Rastvorsprünge auf den Anbauseiten 13, 14 beim Einsetzen einschnappen. Auch die Rastnasen der Eckblendenbefestigungselemente 212 sind in Einführrichtung mit flachen Einführschrägen versehen und tragen auch auf ihren entgegen der Einsetzrichtung angeordneten Seiten vorzugsweise steilere Rastflanken. Als Rastvorsprünge zum Verrasten der Eckblenden 21 dienen z. B. die Rastvorsprünge 135, 145 und 133, 143 auf der Außenseite der Anbauseiten 13, 14.

Die Blenden können vorteilhaft auch zur Übernahme von Schaltschrankfunktionen ausgebildet sein, beispielsweise mit Lüftungsöffnungen und/oder Aussparungen und Aufnahmen von Gittern, Lüftungsmatten, Ventilatoren oder dgl.

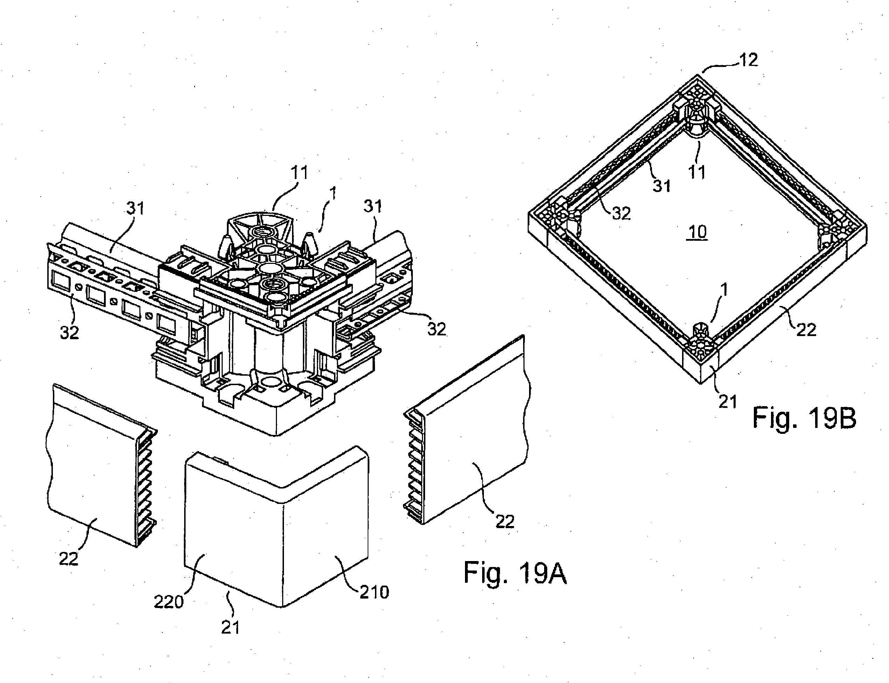

Fig. 19A zeigt einen Ausschnitt eines Eckbereichs einer Konstruktionseinheit mit an einem Montagestück 1 angebrachten Montageschienen 32 und C-Schienen 31 sowie entfernten Seitenblenden 22 und einer Eckblende 21. Fig. 19B zeigt einen Sockel 10 mit daran montierten Blenden 21, 22 sowie mit C-Schienen 31 und Montageschienen 32. Die Eckblenden 21 decken die jeweiligen äußeren Eckräume 120 der Eckstücke 1 ab. Die Seitenblenden können zur Abstützung zusätzlich auch an den Zwischenelementen, insbesondere den Montageschienen 32, in Anlage gebracht und gegebenenfalls daran auch verrastet werden. Dadurch ergibt sich eine zusätzliche Stabilisierung der Seitenblenden 22.

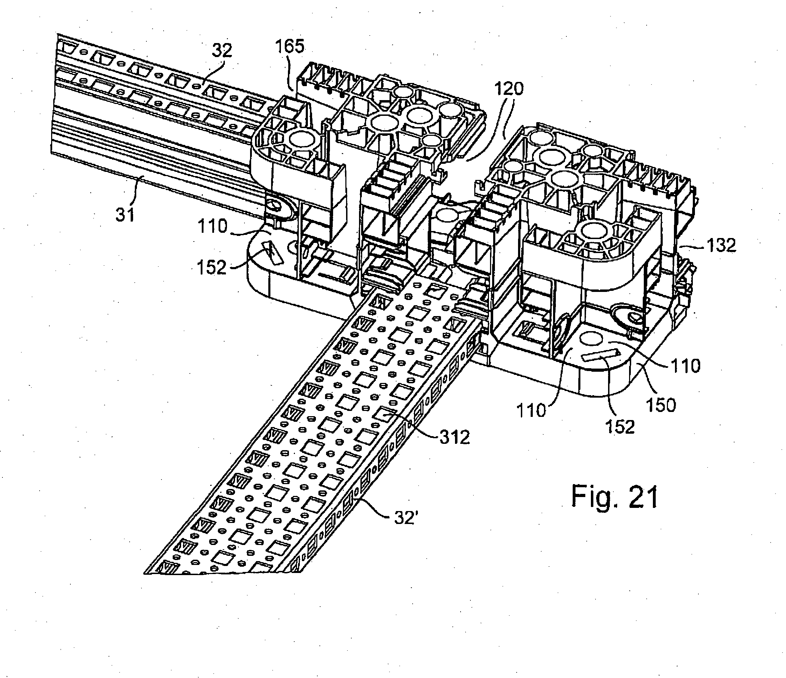

Fig. 20 zeigt einen Ausschnitt eines weiteren Eckbereichs einer Konstruktionseinheit. Hierbei sind an einem Montagestück 1 in der beschriebenen Weise eine Montageschiene 32 und eine C-Schiene 31 mit ihren Endabschnitten an den Aufnahmekammern 141, 142 an der Anbauseite 14 des Montagestückes 1 angebracht. In dem unteren Bereich der Anbauseite 13 ist eine breitere Montageschiene 32' in entsprechende Rastvorsprünge bzw. Nut eingesetzt und ragt mit ihrem von der Anbauseite 13 abgelegenen Randbereich soweit vor, dass sie mit entsprechenden Aufnahmestrukturen an der Anbauseite eines benachbarten entsprechenden Montagestücks 1 in verbindenden Eingriff bringbar ist. Auf diese Weise wird eine seitliche Aneinanderreihung von Konstruktionseinheiten, wie z. B. Sockeln in definierter Anordnung und stabiler Anbindung erreicht. Dies ist in Fig. 21 gezeigt, wobei die breite Montageschiene 32' in die betreffenden Aufnahmekammern der benachbarten Anbauseiten zweier Montagestücke 1 hineinragt und darin verrastet ist. Zur Verrastung können wiederum vorstehende Rastvorsprünge genutzt werden, die an den Anbauseiten 13, 14 der Montagestücke 1 angeformt sind und mit in der Montageschiene 32' angeordneten Löchern von Lochreihen 312 zusammenwirken.

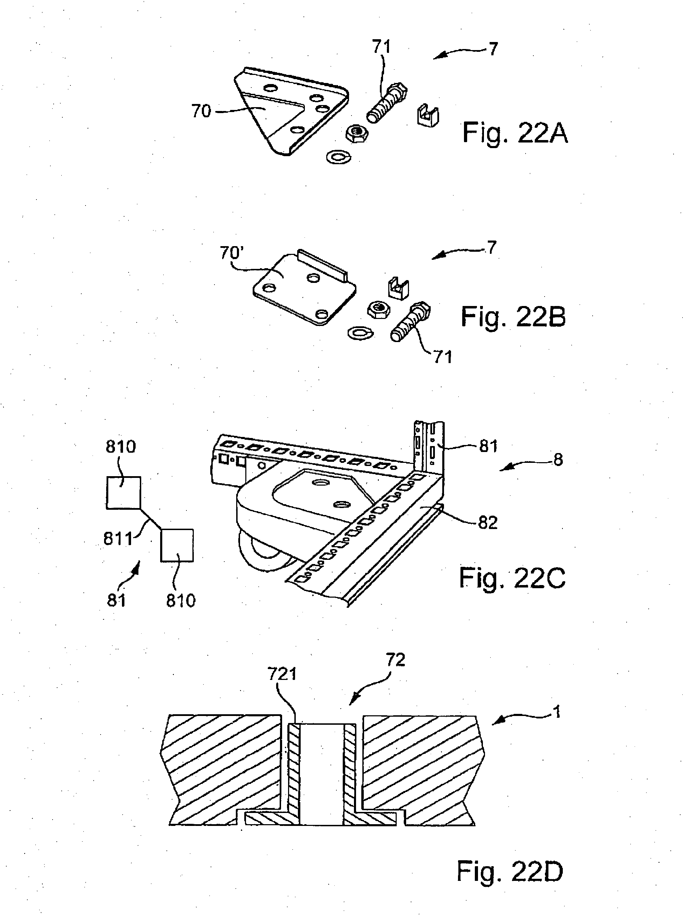

Die Fig. 22A und 22B zeigen verschiedene Adapterelemente 7 umfassend Adapterplatten 70, 70' und darauf abgestimmte Verbindungselemente 71. Fig. 22A zeigt dabei eine im Wesentlichen dreieckförmige Adapterplatte 70, während Fig. 22B eine rechteckförmige Adapterplatte 70' zeigt. Die Adapterplatten weisen Befestigungslöcher auf sowie auf ihren flachen Seiten vorstehende Vorsprünge. Die Vorsprünge und Befestigungslöcher sind an komplementäre Vertiefungen auf der oberen und/oder unteren Grundseite 15, 16 des Montagestückes 1, wie z. B. auch auf deren Randbereich abgestimmt, wobei auch die Befestigungslöcher mit geeigneten Bohrungen in den Grundseiten 15, 16 zur Deckung kommen. Mittels solcher oder ähnlicher Adapterplatten können Anpassungen an unterschiedliche Aufbauten vorgenommen werden, die über die Adapterplatten auf die Montagestücke 1 aufgebracht werden.

Fig. 22C zeigt einen z. 13. auf einem nicht gezeigten Montagestück angebrachten oder anzubringenden Eckausschnitt eines Rahmengestells 8 eines Schaltschranks mit einem vertikalen Rahmenprofil 81 und horizontalen Rahmenprofilen 82. Links ist eine schematische Querschnittsdarstellung des vertikalen Rahmenprofils 81 dargestellt, wobei zwei im Wesentlichen quadratische oder rechteckförmige Hohlkammern bzw. Profilabschnitte 810 über einen diagonal zu diesen verlaufenden Verbindungssteg 811 miteinander verbunden sind. Mit einem solchen Profilquerschnitt werden auf der Außenseite im vertikalen Kantenbereich eines Rahmengestells bzw. Schaltschranks außen und auch innen liegende Freiräume gebildet, die vorteilhafte Montageräume zum Anbringen von Installationselementen, wie z. B. Verbindungselementen für die Seitenbeplankung, Scharniere oder Verschlusselemente bilden. Sind die Profilabschnitte 810 nach außen hin mit vortretenden schmaleren Anlage- oder Dichtstegen versehen, ergeben sich dabei Vorteile für eine dichte Aneinanderreihung wie aus betreffenden Anmeldungen der Anmelderin bekannt, Der im Kantenbereich gebildete Freiraum findet bei dem Aufbau einer Konstruktionseinheit bzw. eines Sockels 10 des vorstehend beschriebenen Aufbaus mit Montagestücken 1, die in den äußeren Eckbereichen freie Eckräume 120 aufweisen, eine systematische Fortsetzung in vertikaler Richtung. Dies ergibt Montagevorteile.

Fig. 22D zeigt ein Beispiel für den Einsatz einer Lagerhülse in einer Bohrung des Eckstücks 1, die vorteilhaft zur Aufnahme eines Verbindungszapfens, etwa einer Rolleneinheit 61 oder eines Stützfußes 63, genutzt werden kann.

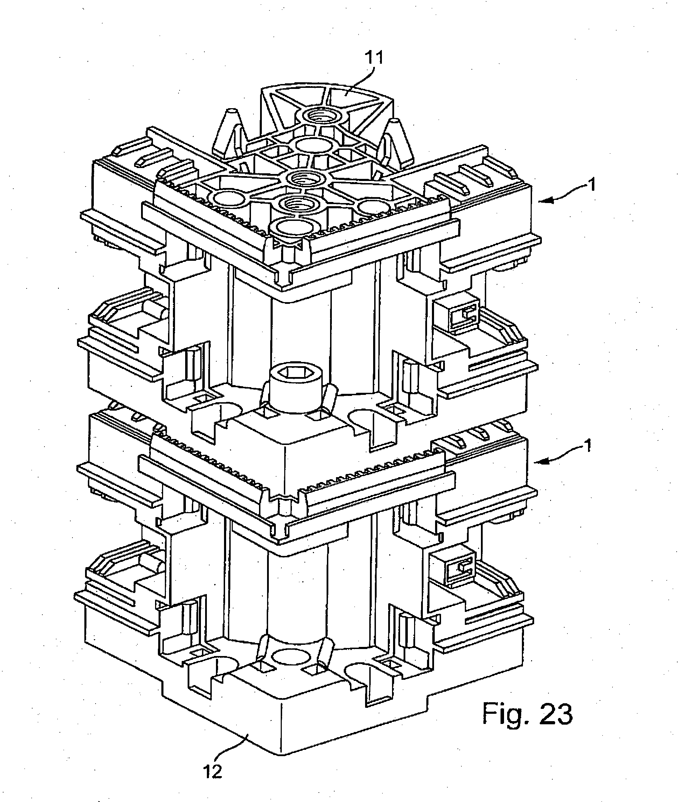

Fig. 23 zeigt die Aneinanderreihung von zwei Montagestücken 1 in z-Richtung. Dabei sind Aufnahmestrukturen auf den beiden Grundseiten 15, 16 aufeinander abgestimmt, so dass sich die aufeinander gesetzten Montagestücke in x- und y-Richtung nicht verschieben und einfach mittels einer durch die miteinander fluchtenden Bohrungen 151, 161 z. B. mittels einer in einem der Eckräume 110, 120 eingesetzten Schraube miteinander verbunden werden können, wie aus der Fig. 23 ersichtlich, insbesondere, wenn in die Bohrungen 161 des oberen Grundwandabschnittes 160 Gewindeeinsätze eingesetzt sind. Auf diese Weise fassen sich Konstruktionseinheiten, wie z. B. Sockel 10, doppelter und bei mehrfacher Aneinanderreihung, mehrfacher Höhe erreichen. Diese können mit jeweiligen Blenden des vorstehend genannten Aufbaus oder doppelt oder mehrfach hohen Blenden einfach abgedeckt werden.

Fig. 24A zeigt einen unteren Abschnitt eines auf einem Sockel 10 mit Montagestücken 1 aufgebauten Rahmengestells 8 eines Recks oder eines Schaltschranks. Das Rahmengestell weist vertikale und horizontale Rahmenprofile 81, 82 der vorstehend

genannten Art auf, wobei die Vertikalprofile 81 im Außenkantenbereich und Innenkantenbereich Freiräume bilden, die vorteilhafte Montagemöglichkeiten ergeben, wie vorstehend ausgeführt. Die Montagestücke bieten ihrerseits freie Eckräume 110, 120 wie beschrieben. Die Montageschienen 32 sind mit Lochreihen 312 mit gleichem Lochraster versehen wie in den horizontalen Rahmenprofilen 82 und den vertikalen Rahmenprofilen 81 ausgebildete Lochraster, wobei die Lochraster der Montageschienen 32 und der horizontalen Rahmenprofile 82 zumindest in vertikaler Richtung zueinander ausgerichtet sind. Ferner sind in die Montagestücke 1 C-Schienen 31 zum Abfangen von Leitungen, insbesondere Kabeln, eingesetzt, wie ebenfalls vorstehend erläutert. Im inneren Eckraum der vertikalen Rahmenprofile 81 sind in dort angeordneten stabilisierenden Aufnahmen Verbindungsschrauben eingesetzt, die sich auf der unteren Seite des von den horizontalen Rahmenprofilen 82 gebildeten unteren Rahmens des Rahmengestells 8 fortsetzen und in entsprechend angeordnete Bohrungen 161 mit darin eingebrachten Gewindeeinsätzen 5 eingreifen. Dabei liegen die durchgeführten Verbindungsschrauben vorteilhaft im außen liegenden Eckbereich 12 bzw. dem äußeren Eckraum 120. Die Oberseite der oberen Grundseite 16 des Montagestücks 1 ist dabei in seiner Aufnahmestruktur an die Unterseite der Horizontalprofile 82 angepasst, wobei z. B. Vorsprünge in betreffende Löcher eintreten können und/oder der äußere Eckbereich der Horizontalprofile 82 von den äußeren leistenartigen Vorsprüngen 164 abschnittsweise begrenzt ist. Die Fig. 24B zeigt den auf dem Sockel aufgebrachten unteren Abschnitt des Rahmengestells 8 in seitlicher Ansicht, die Fig. 24C in Draufsicht und die Fig. 24D und 24E zeigen vergrößert einen Eckbereich in seitlicher Ansicht bzw. in perspektivischer Ansicht. Das Rahmengestell 8 kann mit den Eckstücken 1 über Schrauben, Rastelemente oder Klipselemente und/oder Klemmelemente verbunden werden.

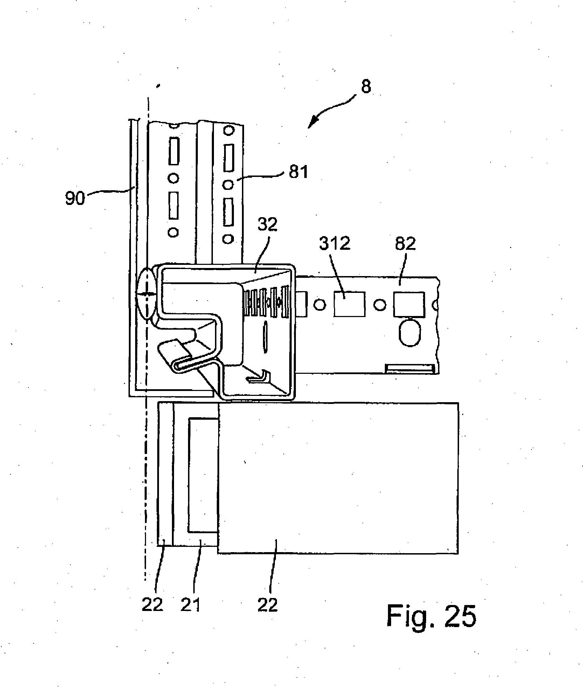

Fig. 25 zeigt einen weiteren Eckbereich eines auf einem Sockel 10 aufgebrachten Rahmengestells 8 mit horizontalen Rahmenprofilen 82 und einem vertikalen Rahmenprofil 81, wobei ein senkrecht zur Zeichenebene verlaufendes Horizontalprofil im Querschnitt dargestellt ist. Dieses bildet in seinem gedachten äußeren Kantenbereich einen umlaufenden Freiraum, in den lediglich ein stegartiger Verbindungsabschnitt vorsteht, wobei aber ansonsten auch in diesem Bereich günstige Montagemöglichkeiten geboten sind. Die flache Unterseite der Horizontalprofile liegt stabil auf der Oberseite des Sockels insbesondere auch der (in dieser Darstellung nicht gezeigten) Montagestücke 1 auf.

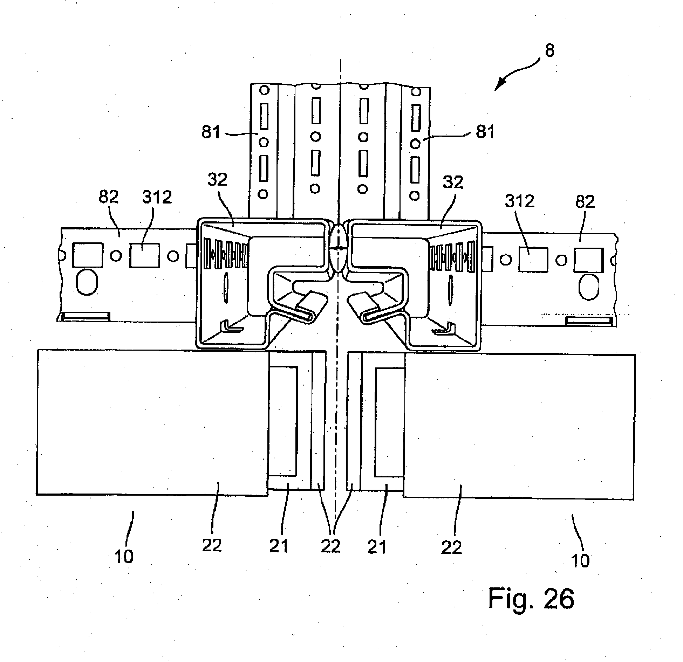

Fig. 26 zeigt eine aneinander gereihte Anordnung mit zwei benachbarten Sockeln und Rahmengestellen 8 in einem Eckbereich. Die horizontalen Rahmenprofile stehen sich dabei mit schmalen Anlagestegen gegenüber, zwischen denen ein Dichtungselement eingefügt ist. Mit ihrer flachen Unterseite liegen sie stabil auf den jeweils zugeordneten Oberseiten zweier Sockel 10. Eine Anreihung von Sockeln bietet z. B. Vorteile bei einer Vormontage, so dass aneinander gereihte Rahmengestelle bzw. Schaltschränke oder Racks einfach aufgesetzt werden können und nur noch fixiert werden müssen.

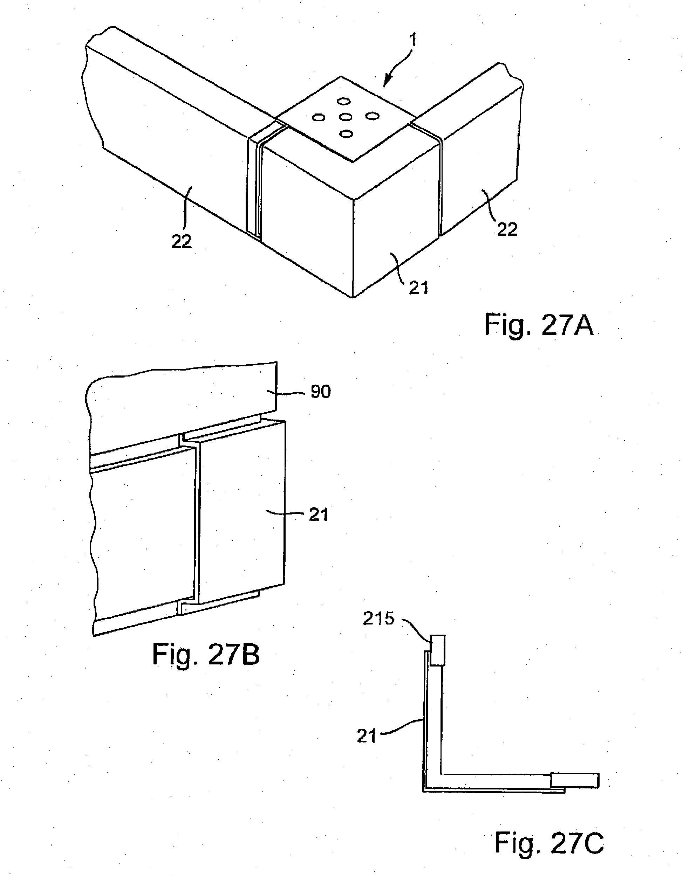

Die Fig. 27A, 27B und 27C zeigen einen Eckbereich eines Sockels mit einem schematisch dargestellten Montagestück 1, an dem eine Blendenanordnung mit Seitenblenden 22 und einer Eckblende 21 angebracht ist. in Fig. 27B ist dabei auch ein Teil einer Schaltschrankwandanordnung 9 mit einem Schaltschrankwandelement 90 gezeigt. Fig. 27C zeigt eine Eckblende 21 in einer Schnittdarstellung, wobei die freien Endabschnitte Z-förmig nach innen etwa um die Dicke des Wandabschnitts abgesetzt sind, so dass die Seitenblenden die abgesetzten freien Endabschnitte der Eckblenden 21 überlappen können, wobei ein bündiger Übergang der Außenflächen erreicht ist.

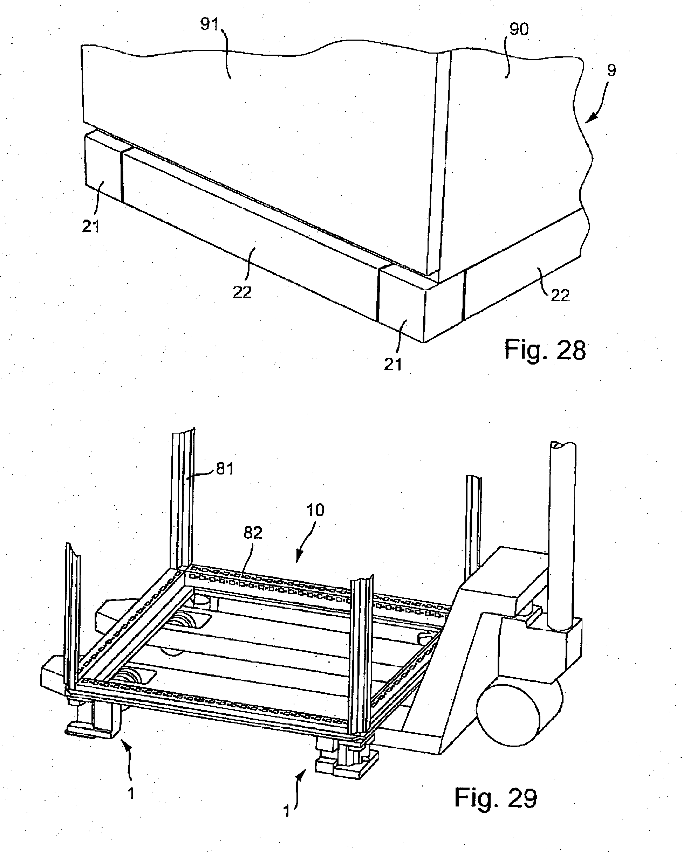

Fig. 28 zeigt einen gegenüber Fig. 27A vergrößerten Ausschnitt eines Sockels mit Seitenblenden und Eckblenden sowie einen Ausschnitt eines Schaltschranks mit einer Schaltschrankwandanordnung 9 mit Schaltschrankwandelementen 90 und z. B. einer Tür 91.

Fig. 29 zeigt einen auf einem unverkleideten Sockel mit Montagestücken 1 aufgebrachten unteren Rahmengestellabschnitt, womit im Sockelbereich Tragarme eines Hubgeräts eingeschoben sind. Die Montagestücke 1 bilden dabei vorteilhafte Distanzstücke zum Einführen der Tragarme ähnlich einer Palette. Dies bringt Transportvorteile.

Eine mittels der Montagestücke 1 aufgebaute Konstruktionseinheit lässt sich nicht nur als Sockel 10 verwenden, sondern beispielsweise auch als Zwischenrahmen zwischen zwei aufeinander montierten Rahmengestellen 8 oder als Aufsatzrahmen. Auch eine Verwendung als Anbaurahmen ist denkbar. Dabei kann die z-Richtung der Montagestücke in horizontaler Richtung zeigen bzw. die Ebene der Konstruktionseinheit, wie Anbaurahmen vertikal ausgerichtet sein.

## Patentansprüche

1. Sockel oder Anbaurahmen für einen Schaltschrank oder ein Rack mit in den Eckbereichen eines in einer x-y-Ebene sich erstreckenden Rechtecks oder Quadrats als Eckstücke angeordneten Montagestücken (1), die jeweils in einem Formungsprozess hergestellt und eine sich in x-Richtung und eine sich dazu rechtwinklig in y-Richtung erstreckende bezüglich des Rechtecks oder Quadrats außen liegende und in zur x-y-Ebene rechtwinkliger Raumrichtung z ausgedehnte erste und zweite Anbauseiten (13, 14) aufweisen, an denen Abschnitte einer Anordnung von Blenden (2) in Anlage gebracht sind, wobei die Blenden (2) Seitenblenden (22) mit einer außen flachen Blendenwand (220) umfassen und über Verbindungsmittel an Aufnahmestrukturen der Montagestücke (1) angebracht sind, wobei die Seitenblenden (2) mit auf ihrer Innenseite angeformten Blendenbefestigungselementen (221) versehen sind, mit denen sie unmittelbar oder mittelbar an den Aufnahmestrukturen der Montagestücke (1) befestigt sind, wobei sich die Blendenbefestigungselemente (221) in Längsrichtung der Seitenblenden (22) auf einer Innenseite der Blendenwand (220) erstrecken
**dadurch gekennzeichnet**,
dass die Blendebefestigungselemente (221) rechtwinklig von der Innenseite der Blendenwand (220) vorstehen, so dass sie Versteifungselemente bilden, und dass die Seitenblenden aus Metall oder vorzugsweise Kunststoff in einem Strangformungs-prozess gefertigt sind, wobei die Seitenblenden (22) wahlweise an der Innenseite der Blendenwand (220) mit in Längsrichtung verlaufenden Versteifungsrippen (222) versehen sind.

2. Sockel oder Anbaurahmen nach Anspruch 1, **dadurch gekennzeichnet, dass** die Blendenbefestigungselemente (221) als Klipselemente oder als Rastelemente mit flacher Einführschräge und steilem Rastabsatz ausgebildet sind und unter federelastischer Auslenkung an darauf abgestimmten Aufnahmestrukturen an den Anbauseiten (13, 14) der Montagestücke (1) oder an zwischen den Montagestücken (1) verlaufenden und mit ihren Endabschnitten an diesen angebrachten weiteren Zwischenelementen, wie Montageschiene (32) oder C-Schiene (31), in Eingriff gebracht oder bringbar sind, um die Seitenblenden zu fixieren, wobei die Blendenbefestigungselemente (221) und/oder die Aufnahmestrukturen federelastisch auslenkbar sind.

3. Sockel oder Anbaurahmen nach Anspruch 1 oder 2, **dadurch gekennzeichnet, dass** die Anordnung der Blenden (2) auch Eckblenden (21) umfasst, die zum Abdecken der außen liegenden Eckbereiche der Montagestücke (1) ausgebildet sind.

4. Sockel oder Anbaurahmen nach Anspruch 3, **dadurch gekennzeichnet, dass** die Eckblenden (21) auf ihrer Innenseite mit angeformten Eckblendenbefestigungselementen (212, 213) versehen sind, mit denen sie unmittelbar oder mittelbar an zugeordneten Aufnahmestrukturen des Montagestückes (1) anbringbar sind.

5. Sockel oder Anbaurahmen nach Anspruch 3 oder 4, **dadurch gekennzeichnet, dass** auch die Eckblenden (21) aus Metall oder vorzugsweise Kunststoff geformt sind und auf der Innenseite ihrer plattenförmigen Eckblendenwände mit angeformten Versteifungsstrukturen versehen sind.

6. Sockel oder Anbaurahmen nach Anspruch 4 oder 5, **dadurch gekennzeichnet, dass** die Eckblenden (21) zum Herstellen eines glatten Übergangs von ihrer Außenseite zur Außenseite der Seitenblenden (22) mit den zugekehrten Endabschnitten der Seitenblenden (22) überlappende Endabschnitte aufweisen, die um die Dicke der Blendenwand (220) z-förmig nach innen abgesetzt sind.

7. Sockel oder Anbaurahmen nach einem der vorhergehenden Ansprüche, **dadurch gekennzeichnet**,
dass die Aufnahmestrukturen der Montagestücke (1) parallel zu der betreffen den Anbauseite (13, 14) verlaufende Aufnahmekammern (131, 132; 141, 142) aufweisen, die von in ihrer Orientierungsrichtung verlaufenden Wandabschnitten (137, 137'; 147, 147') zumindest teilweise umgeben und auf ihren voneinander abgekehrten Stirnseiten offen sind, und/oder
dass die Aufnahmestrukturen Aufnahmerippen, Aufnahmenuten, Aufnahmestege, andere Vorsprünge und/oder andere Vertiefungen aufweisen und
dass zumindest ein Teil der Aufnahmestrukturen mit Befestigungsmitteln, insbesondere angeformten Rastmitteln, versehen ist, die mit den Blenden (2) und/oder mit zwischen den Montagestücken (1) verlaufenden Zwischenelementen in Eingriff bringbar sind.

8. Sockel oder Anbaurahmen nach einem der vorhergehenden Ansprüche, **dadurch gekennzeichnet, dass** die Montagestücke (1) in z-Richtung von einer ersten und einer davon in einem Abstand (d) parallel beabstandeten zweiten Grundseite (15, 16) abgeschlossen sind, die in der x-y-Ebene orientiert sind und die Außenseite mindestens eines ersten und mindestens eines zweiten Grundwandabschnitts (150, 160) bilden, und
dass die Anbauseiten (13, 14) an ihren einander zugekehrten Enden voneinander beabstandet sind und in dem betreffenden ersten gedachten Eckbereich des Montagestücks einen ersten Eckraum (120) bilden, der mit Blenden der Anordnung abdeckbar ist

9. Sockel oder Anbaurahmen nach Anspruch 8, **dadurch gekennzeichnet, dass** sich auf den Innenseiten der voneinander weg gerichteten Enden der ersten und der zweiten Anbauseite weitere Wandbereiche anschließen, die miteinander einstückig verbunden sind und zwischen ihren einander zugekehrten Enden einen zweiten Eckraum (110) freilassen, der in z-Richtung mittels des ersten und des zweiten Grundwandabschnittes (150, 160) begrenzt ist.

10. Sockel oder Anbaurahmen nach einem der vorhergehenden Ansprüche, **dadurch gekennzeichnet, dass** die Montagestücke (1) als blockartige Kunststoffformteile ausgebildet sind.

11. Sockel oder Anbaurahmen nach einem der vorhergehenden Ansprüche, **dadurch gekennzeichnet, dass** zum Bilden eines Rahmens doppelter oder mehrfacher Höhe in den Eckbereichen jeweils zwei oder mehr Montagestücke (1) in z-Richtung angeordnet und miteinander verbunden sind.

## Claims

1. A socket or a mounting frame for a switchgear cabinet or a rack, comprising mounting pieces (1) which are arranged, as corner pieces, in the corner regions of a rectangle or square that extends in an x-y plane, said mounting pieces being produced in a respective shaping process and comprising first and second mounting faces (13, 14) which lie outside with respect to the rectangle or square, which extend in the x direction and in the y direction at a right angle thereto and which extend in a space direction z at a right angle to the x-y plane, wherein sections of a system of covers (2) are brought into contact with the mounting faces, said covers (2) having lateral covers (22) with cover walls (220) that are flat on the exterior and that have reinforcing ribs (222) extending longitudinally on the interior, and being fastened to receiving structures of the mounting pieces (1) by connecting means, wherein the lateral covers (2) have cover fastening elements (221) formed onto the interior of the lateral covers by which they are fastened directly or indirectly to the receiving structures of the mounting pieces (1) by means of said cover fastening elements, wherein the cover fastening elements (221) extend in longitudinal direction of the lateral covers (22) on an interior of the cover wall (220),
**characterized in that** the cover fastening elements (221) protrude perpendicularly from the interior of the cover wall to form reinforcing elements and that the lateral covers are made of metal or preferably of plastics in an extrusion process, wherein the lateral covers (22) are selectively provided with longitudinally running reinforcing ribs (222) on the interior of the cover wall.

2. The socket or mounting frame of claim 1, **characterized in that** the cover fastening elements (221) are formed as clip elements or a locking elements having a flat insert slope and a steep locking step and are engaged or can be engaged, by means of resilient deflection, with respectively adapted receiving structures at the mounting faces (13, 14) of the mounting pieces (1) or at other intermediate elements, such as mounting rail (32) or C-rail (31), extending between the mounting pieces (1) and mounted thereto with their end sections, to fix the lateral covers, wherein the cover fastening elements (221) and/or the receiving structures can be resiliently deflected.

3. The socket or mounting frame of claim 1 or 2, **characterized in that** the system of covers (2) also includes corner covers (21) which are configured to cover the outer corner regions of the mounting pieces (1).

4. The socket or mounting frame of claim 3, **characterized in that** the corner covers (21) are provided with corner cover fastening elements (212, 213) formed onto the interior thereof by which they can be fastened directly or indirectly to associated receiving structures of the mounting piece (1).

5. The socket or mounting frame of claim 3 or 4, **characterized in that** also the corner covers (21) are made of metal or preferably of plastics and are provided with reinforcing structures formed onto the interior of plate-shaped corner cover walls thereof.

6. The socket or mounting frame of claim 4 or 5, **characterized in that** the corner covers (21), in order to achieve at a smooth transition from an exterior thereof to the exterior of the lateral covers (22), comprise end sections overlapping facing end sections of the lateral covers, which are inwardly offset by the thickness of the cover wall (220) in a z shaped manner.

7. The socket or mounting frame of one of the preceding claims, **characterized in that** the receiving structures of the mounting pieces (1) comprise receiving chambers (131, 132; 141, 142) running parallel to the relevant mounting face (13, 14), which are at least partly surrounded by wall sections (137, 137'; 147, 147') running in their orientation direction and which are open at their front ends facing away from each other, and/or that the receiving structures comprise receiving ribs, receiving grooves, receiving bars, other protrusions and/or other depressions and that at least a proportion of the receiving structures is provided with fastening means, in particular locking means formed thereon, which can be engaged with the covers (2) and/or with intermediate elements extending between the mounting pieces (1).

8. The socket or mounting frame of one of the preceding claims, **characterized in that** the mounting pieces (1) terminate in z direction in a first and a second base face (15, 16) oriented in the x-y plane, the second base face being parallel and spaced apart from the first base face by a distance (d), both forming the outer face of at least a first and at least a second base wall section (150, 160), and that the mounting faces (13, 14) are spaced apart from another at their ends facing towards another and form a first corner space (120) in the relevant first virtual corner region of the mounting piece (1) which can be covered with the covers of the system.

9. The socket or mounting frame of claim 8, **characterized in that** further wall sections are coupled to the interior of the ends of the first and second mounting face, which ends are facing away from another, said wall sections being integrally connected and leave a second corner space (110) between their ends facing towards another, which is confined in z direction by the first and the second base wall section (150, 160).

10. The socket or mounting frame of one of the preceding claims, **characterized in that** the mounting pieces (1) are shaped as block-like plastic molded parts.

11. The socket or mounting frame of one of the preceding claims, **characterized in that** for producing a frame of double or multiple height, two or more mounting pieces (1) are respectively arranged in the corner regions in z direction and are connected to another.

## Revendications

1. Socle ou châssis de montage pour une armoire de commande ou un rack, comportant des pièces de montage (1), qui sont disposées en tant qu'éléments d'angle dans les coins d'un rectangle ou carré s'étendant dans un plan x-y et qui ont été réalisées chacune dans un processus de formage et comportent une première et deuxième face de montage (13, 14) qui s'étendent l'une dans la direction x et l'autre perpendiculairement à celle-ci dans la direction y, sont situées à l'extérieur par rapport au rectangle ou carré et s'étendent dans une direction dans l'espace perpendiculaire au plan x-y et contre lesquelles ont été mises en appui des parties d'un ensemble de caches (2), lesdits caches (2) comportant des caches latéraux (22) avec une paroi extérieure (220) plane et étant attachés à des structures de réception des pièces de montage (1) par l'intermédiaire de moyens de liaison, lesdits caches latéraux (2) étant munis d'éléments de fixation des caches (221), qui sont formés sur leur face intérieure et par lesquels ils sont directement ou indirectement fixés aux structures de réception des pièces de montage (1), lesdits éléments de fixation des caches (221) s'étendant dans le sens longitudinal des caches latéraux (22) sur une face intérieure de la paroi de cache (220),
**caractérisé en ce que**
les éléments de fixation des caches (221) s'avancent en saillie perpendiculairement sur la face intérieure de la paroi de cache (220), de telle sorte qu'ils forment des éléments de raidissement, et **en ce que** les caches latéraux sont réalisés en métal ou de préférence en matière plastique dans un processus de moulage par extrusion, lesdits caches latéraux (22) étant munis au choix, sur la face intérieure de la paroi de cache (220), de nervures de raidissement (222) orientées dans le sens longitudinal.

2. Socle ou châssis de montage selon la revendication 1, **caractérisé en ce que** les éléments de fixation des caches (221) sont réalisés sous forme d'éléments à clipser ou d'éléments à enclencher avec une rampe d'introduction plane et un talon de blocage à pente raide et, pour fixer les caches latéraux, sont amenés en prise ou peuvent être amenés en prise, moyennant une déviation élastique, sur des structures de réception ajustées auxdits éléments de fixation des caches sur les faces de montage (13, 14) des pièces de montage (1) ou sur des éléments intermédiaires supplémentaires, tels que des rails de montage (32) ou des rails en forme de C (31), qui s'étendent entre les pièces de montage (1) et sont attachés à celles-ci par leurs extrémités, les éléments de fixation des caches (221) et/ou les structures de réception pouvant être déviées élastiquement.

3. Socle ou châssis de montage selon la revendication 1 ou 2, **caractérisé en ce que** l'ensemble de caches (2) comporte aussi des caches d'angle (21) qui sont réalisés pour masquer les zones d'angle extérieures des pièces de montage (1).

4. Socle ou châssis de montage selon la revendication 3, **caractérisé en ce que** les caches d'angle (21) sont munis sur leur face intérieure d'éléments de fixation des caches d'angle (212, 213), qui sont formés sur ladite face intérieure et par lesquels ils peuvent être attachés directement ou indirectement aux structures de réception associées de la pièce de montage (1).

5. Socle ou châssis de montage selon la revendication 3 ou 4, **caractérisé en ce que** les caches d'angle (21) sont réalisés en métal ou, de préférence, en matière plastique et sont munis de structures de raidissement formées sur la face intérieure de leur paroi en forme de plaque.

6. Socle ou châssis de montage selon la revendication 4 ou 5, **caractérisé en ce que** les caches d'angle (21), en vue de la réalisation d'une transition lisse entre leur face extérieure et la face extérieure des caches latéraux (22), comportent des extrémités, qui se chevauchent avec les extrémités orientées vers elles des caches latéraux (22) et qui présentent un décrochage vers l'intérieur en forme de z d'une valeur correspondant à l'épaisseur de la paroi de cache (220).

7. Socle ou châssis de montage selon l'une quelconque des revendications précédentes, caractérisé
en ce que les structures de réception des pièces de montage (1) comportent des chambres de réception (131, 132; 141, 142), qui sont parallèles à la face de montage (13, 14) concernée et qui sont entourées au moins en partie par des tronçons de paroi (137, 137'; 147, 147'), s'étendant dans leur direction d'orientation, et sont ouvertes sur leurs faces frontales détournées l'une de l'autre, et/ou
en ce que les structures de réception comportent des nervures de réception, des rainures de réception, des barrettes de réception, d'autres saillies et/ou d'autres creux, et
en ce qu'au moins une partie des structures de réception sont munies de moyens de fixation, en particulier des moyens de blocage, qui sont formés contre lesdites structures et qui peuvent être amenés en prise avec les caches (2) et/ou avec des éléments intermédiaires qui s'étendent entre les pièces de montage (1).

8. Socle ou châssis de montage selon l'une quelconque des revendications précédentes, **caractérisé en ce que** les pièces de montage (1), dans la direction z, sont fermées par une première face de base (15) et une deuxième face de base (16) parallèlement écartée de la première sur une distance (d), lesquelles sont orientées dans le plan x-y et forment la face extérieure d'au moins une première et d'au moins une deuxième partie de paroi de base (150, 160), et
**en ce que** les faces de montage (13, 14) sont écartées l'une de l'autre au niveau de leurs extrémités orientées l'une vers l'autre et, dans la première zone d'angle imaginaire concernée de la pièce de montage, forment un premier espace d'angle (120) qui peut être masqué par des caches de l'ensemble de caches.

9. Socle ou châssis de montage selon la revendication 8, **caractérisé en ce que** les faces intérieures des extrémités s'écartant l'une de l'autre de la première et de la deuxième face de montage sont prolongées par d'autres zones de paroi qui sont reliées entre elles d'un seul tenant et libèrent entre leurs extrémités orientées l'une vers l'autre un deuxième espace d'angle (110) qui est limité dans la direction z par la première et la deuxième partie de paroi de base (150, 160).

10. Socle ou châssis de montage selon l'une quelconque des revendications précédentes, **caractérisé en ce que** les pièces de montage (1) sont réalisés sous la forme de pièces moulées en forme de bloc en matière plastique.

11. Socle ou châssis de montage selon l'une quelconque des revendications précédentes, **caractérisé en ce que** pour former un châssis avec une hauteur double ou multiple, respectivement deux ou plusieurs pièces de montage (1) sont disposées dans les zones d'angle dans la direction z et sont reliées l'une à l'autre.
